# EUROPEAN PATENT APPLICATION

(11) **EP 4 748 965 A2**
(43) Date of publication of application: **27.05.2026**
(21) Application number: 26157978.3
(22) Date of filing: 08.08.2024
(51) Int. Cl.: C23C 16/02

(54) **FORMULATIONS FOR SELECTIVE DEPOSITION**

(30) Priority: 11.08.2023 US 202363518929 P
(62) Divisional of application: 24755492.6
(71) Applicant: Merck Patent GmbH, 64293 Darmstadt (DE)
(72) Inventor: Clough, Christopher R., Wilmington, 19808 (US); Thode, Christopher Jay, St. Louis, 63103 (US); Hopkins, Christopher David, Tempe, 85284 (US); Ivanov, Sergei V., Tempe, 85284 (US); Derecskei, Agnes, Tempe, 85284 (US); Cooper, Alan C., Tempe, 85284 (US)
(74) Representative: Merck Patent Association

(57) **Abstract**

The disclosed and claimed subject matter relates to formulations that include (i) one or more alkynes in combination with (ii) one or more tertiary alcohols as well as their use for enhanced passivation of metallic substrates.

## Description

### BACKGROUND

### Field

The disclosed and claimed subject matter relates to formulations useful for selective deposition of dielectric films on non-metallic substrates. In particular, the disclosed and claimed subject matter relates to formulations that include (i) one or more alkynes in combination with (ii) one or more tertiary alcohols as well as their use for enhanced passivation of metallic substrates.

### Related Art

Transition metal-containing films are used in semiconductor and electronics applications. Chemical Vapor Deposition (CVD) and Atomic Layer Deposition (ALD) have been applied as the main deposition techniques for producing thin films for semiconductor devices. These methods enable the achievement of conformal films (metal, metal oxide, metal nitride, metal silicide, and the like) through chemical reactions of metal-containing compounds (precursors). The chemical reactions occur on surfaces which may include metals, metal oxides, metal nitrides, metal silicides, and other surfaces. In CVD and ALD, the precursor molecule plays a critical role in achieving high quality films with high conformality and low impurities. The temperature of the substrate in CVD and ALD processes is an important consideration in selecting a precursor molecule. Higher substrate temperatures, in the range of 150 to 500 degrees Celsius (°C), promote a higher film growth rate. The preferred precursor molecules must be stable in this temperature range. The preferred precursor is capable of being delivered to the reaction vessel in a liquid phase. Liquid phase delivery of precursors generally provides a more uniform delivery of the precursor to the reaction vessel than solid phase precursors.

CVD and ALD processes are increasingly used as they have the advantages of enhanced compositional control, high film uniformity, and effective control of doping. Moreover, CVD and ALD processes provide excellent conformal step coverage on highly nonplanar geometries associated with modern microelectronic devices. CVD and ALD are specifically attractive for fabricating conformal metal containing films on substrates, such as silicon, silicon oxide, metal nitride, metal oxide and other metal-containing layers, using these metal-containing precursors. In these techniques, a vapor of a volatile metal complex is introduced into a process chamber where it contacts the surface of a silicon wafer whereupon a chemical reaction occurs that deposits a thin film of pure metal or a metal compound.

CVD is a chemical process whereby precursors are used to form a thin film on a substrate surface. In a typical CVD process, the precursors are passed over the surface of a substrate (*e.g.,* a wafer) in a low pressure or ambient pressure reaction chamber. The precursors react and/or decompose on the substrate surface creating a thin film of deposited material. Plasma can be used to assist in reaction of a precursor or for improvement of material properties. Volatile by-products are removed by gas flow through the reaction chamber. The deposited film thickness can be difficult to control because it depends on coordination of many parameters such as temperature, pressure, gas flow volumes and uniformity, chemical depletion effects, and time. Thus, CVD occurs where the precursor reacts at the wafer surface either thermally or with a reagent added simultaneously into the process chamber and the film growth occurs in a steady state deposition. CVD can be applied in a continuous or pulsed mode to achieve the desired film thickness.

ALD is a chemical method for the deposition of thin films. It is a self-limiting, sequential, unique film growth technique based on surface reactions that can provide precise thickness control and deposit conformal thin films of materials provided by precursors onto surfaces substrates of varying compositions. In ALD, the precursors are separated during the reaction. The first precursor is passed over the substrate surface producing a monolayer on the substrate surface. Any excess unreacted precursor is pumped out of the reaction chamber. A second precursor or co-reactant is then passed over the substrate surface and reacts with the first precursor, forming a second monolayer of film over the first-formed monolayer of film on the substrate surface. Plasma may be used to assist with reaction of a precursor or co-reactant or for improvement in materials quality. This cycle is repeated to create a film of desired thickness. ALD provides the deposition of ultra-thin yet continuous metal containing films with precise control of film thickness, excellent uniformity of film thickness and outstandingly conformal film growth to evenly coat deeply etched and highly convoluted structures such as interconnect vias and trenches. Thus, ALD is typically preferred for deposition of thin films on features with high aspect ratio.

Thin films, and in particular thin metal-containing films, have a variety of important applications, such as in nanotechnology and the fabrication of semiconductor devices. Examples of such applications include capacitor electrodes, gate electrodes, adhesive diffusion barriers and integrated circuits. However, the continual decrease in the size of microelectronic components, such as semi-conductor devices, presents several technical challenges and has increased the need for improved thin film technologies. In particular, microelectronic components may include features on or in a substrate, which require filling, *e.g*., to form a conductive pathway or to form interconnections. Filling such features, especially in smaller and smaller microelectronic components, can be challenging because the features can become increasingly thin or narrow. Consequently, a complete filling of the feature, e.g., via ALD, would require infinitely long cycle times as the thickness of the feature approaches zero. Moreover, once the thickness of the feature becomes narrower than the size of a molecule of a precursor, the feature cannot be completely filled. As a result, a hollow seam can remain in a middle portion of the feature when ALD is performed. The presence of such hollow seams within a feature is undesirable because they can lead to failure of the device. Accordingly, there exists significant interest in the development of thin film deposition methods, particularly ALD methods that can selectively grow a film on one or more substrates and achieve improved filling of a feature on or in a substrate, including depositing a metal-containing film in a manner which substantially fills a feature without any voids.

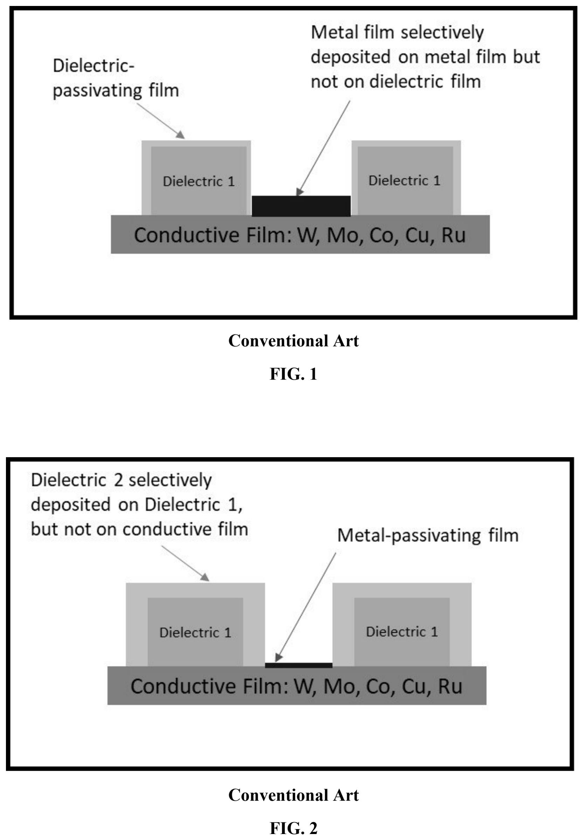

As alluded to above, in conventional semiconductor device fabrication, patterning is a "top-down" process based largely on photolithography and etching, which is a main bottleneck for device downscaling. In contrast, area selective deposition (*e.g*., CVD and ALD) provides an alternative "bottom-up" method for patterning for advanced semiconductor manufacturing where a metal layer (*e.g*., Ru) is grown on bottom metal surface (*e.g*., Ru and TiN) proximate to the passivated dielectric substrate, but not on a dielectric (*e.g*., SiO₂) sidewall. *See, e.g*., FIG. 1. It is also desirable that these processes be oxygen free and/or have lower resistivity.

In another application it is desired to deposit dielectric film only on another dielectric film but not on metal surface. *See, e.g*., FIG. 2. One potential application for such process is self-aligned fabrication. Most common strategy to achieve selective growth is based on selective passivation of non-growth surface. Small volatile molecules are highly desired for passivation because they can be supplied via vapor phase. Selective passivation of non-metallic surfaces with high concentration of hydroxyl groups is being widely utilized and includes reaction with various silylating agents, such as RₓSiCl_{y}, RₓSi(NR₂)_{y}, *etc.* On the other hand, selective passivation of metallic surfaces is much more challenging and selectivity by this approach can be easily lost by desorption of passivating agent and incomplete passivation due to residual impurities on the surface of metal film, *etc.* Typically, single component reagents are used to passivate non-growth surface. However, single component reagents may not provide complete surface coverage of metal surface due to presence of different sites on the metal surface, such as for example "naked" metal, metal terminated with hydrogen atom, metal terminated with oxygen atom or hydroxyl group, *etc.*

Alkynes have been used for passivation of metallic surfaces to substantially suppress growth of a film on metallic non-growth surface while depositing the film on a growth dielectric surface. However, alkynes provide insufficient passivation on metal sites terminated with oxygen atom or hydroxyl groups and require additives to assist in passivation of these residual sites.

For example, U.S. Patent Application Publication No. 2020/0347493 discloses methods for selective deposition of dielectric films on non-metallic surfaces. The disclosed method requires passivation or blocking of metallic surface prior to deposition of the dielectric films. In some embodiments the method includes treatment of metallic surface with unsaturated hydrocarbons having at least one carbon-carbon triple bond (*e.g*., 3-hexyne, 4-octyne, 5-decyne, 6-dodecyne and 7-tetradecyne). According to the application, it is believed that the unsaturated hydrocarbons suppress nucleation and growth on the metallic substrate. While the application provides a method to block metallic surface it fails to teach or suggest a process for passivating residual metal oxide sites that are present on the metallic surface.

Reproducible selective passivation of metallic surface requires careful design of the precursors and deposition processes. Indeed, it is highly desired to reduce and/or eliminate passivation of dielectric surfaces while enhancing passivation of metallic surface. The disclosed and claimed subject matter provides compositions and methods for enhanced passivation and/or blocking of metallic surfaces and enhanced selective deposition of non-metallic surfaces relative to metallic surfaces.

To achieve selective surface growth (*i.e*., the simultaneous or substantially simultaneous growth and non-growth on different surfaces) during semiconductor manufacturing, it is typically desirable to utilize (i) a metallic surface assumed to be free or substantially free of hydroxyl groups and (ii) a non-metallic surface containing high concentration of hydroxyl groups. Examples of suitable metallic surfaces include, but are not limited to, copper, cobalt, tungsten, molybdenum, nickel, ruthenium, *etc.* Examples of non-metallic surfaces include, but are not limited to, silicon oxide, low K carbon-doped silicon oxides, silicon nitrides, silicon carbonitrides, and metal oxides such as aluminum oxide, tantalum oxide, hafnium oxide, zirconium oxide, *etc.* Examples of the films deposited on non-metallic surface include, but are not limited to, silicon oxide, aluminum oxide, tantalum oxide, titanium oxide, hafnium oxide, zirconium oxide, tantalum nitride, titanium nitride, *etc.* The films are deposited on non-metallic surface by chemical vapor deposition and atomic layer deposition processes discussed above. The precursors useful for deposition of the films include, but not limited to, trimethylaluminum, *tetrakis*(dimethylamido)titanium, *pentakis*(dimethylamido)tantalum, *tert-*butylimido-*tris*(dimethylamido)tantalum, *tert*-butylimido-*tris*(dimethylamido) niobium, *etc.* Co-reactants include, but are not limited to, water and ammonia.

To achieve selective deposition, the metallic surface must be passivated and be free or substantially free of chemical groups reactive toward precursors and co-reactants used in next process step for film deposition, such as for example ammonia. On the other hand, the reactant used for passivation of metallic surface should not passivate desired growth on the non-metallic surface. The disclosed and claimed formulations are uniquely designed to balance these needs in selective deposition processes.

### SUMMARY

The disclosed and claimed subject matter relates to formulations that include, consist essentially of and/or consist of (i) one or more alkynes in combination with (ii) one or more tertiary alcohols as well as their use for enhanced passivation of metallic substrates. In one embodiment, the formulation includes, consists essentially of or consists of (ii) one or more alcohol that is an acetylenic compound that includes a tertiary alcohol.

In another embodiment, the disclosed and claimed subject matter includes the use of the above-described formulations in selective CVD deposition processes.

In another embodiment, the disclosed and claimed subject matter includes the use of the above-described formulations in selective ALD deposition processes.

### BRIEF DESCRIPTION OF THE DRAWINGS

The accompanying drawings, which are included to provide a further understanding of the disclosed subject matter and are incorporated in and constitute a part of this specification, illustrate embodiments of the disclosed subject matter and together with the description serve to explain the principles of the disclosed subject matter. In the drawings:
FIG. 1 illustrates an exemplary target of selective deposition processes where metal film is selectively deposited on conductive film, while dielectric film is passivated;
FIG. 2 illustrates an exemplary target of selective deposition processes where dielectric film is selectively deposited on dielectric film, while metal surface is passivated;

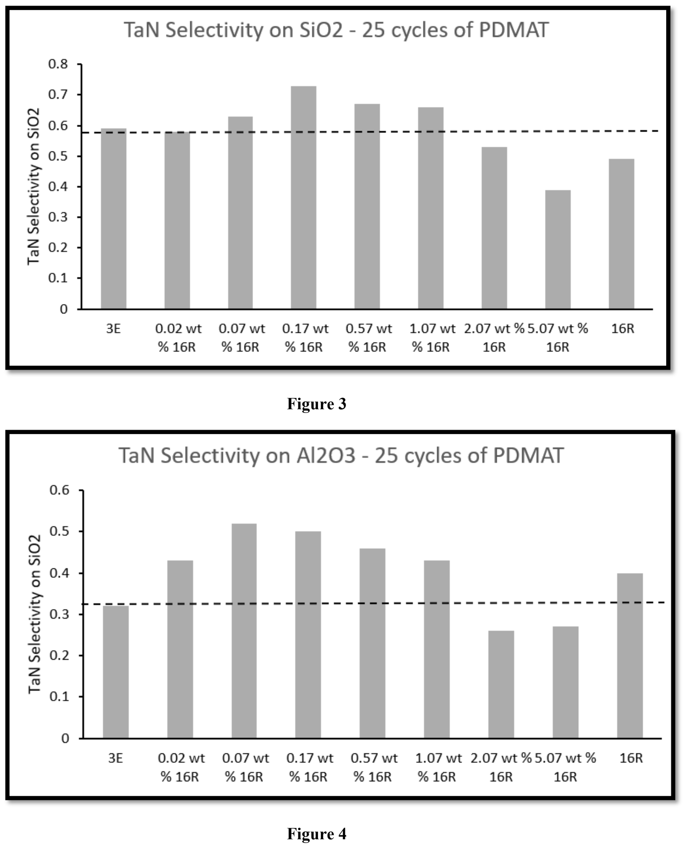

FIG. 3 illustrates process selectivity for depositing TaN on Cu and SiO₂ wherein passivation formulation includes 5-decyne (3E) with various concentrations of an acetylenic compound that includes a tertiary alcohol, 2-methyl-3-octyn-2-ol (16R). The graph shows unexpected improvement in selectivity in the range of alcohol concentrations between 0.02 and 2 wt%;
FIG. 4 illustrates process selectivity for depositing TaN on Cu and aluminum oxide wherein passivation formulation includes 5-decyne (3E) with various concentrations of an acetylenic compound that includes a tertiary alcohol, 2-methyl-3-octyn-2-ol (16R). The graph shows unexpected improvement in selectivity in the range of alcohol concentrations between 0.02 and 2 wt%;

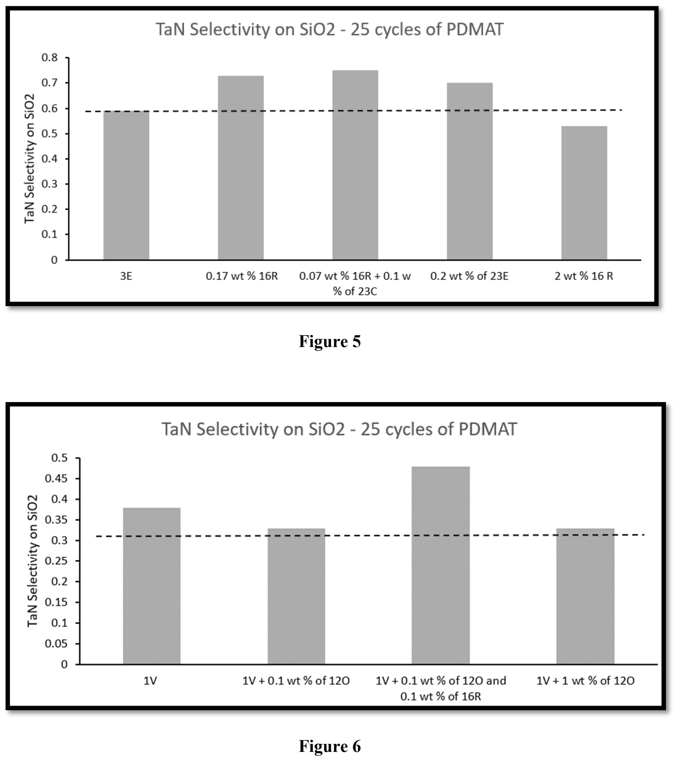

FIG. 5 illustrates process selectivity for depositing TaN on Cu and SiO₂ wherein passivation formulation includes 5-decyne (3E) with three different acetylenic compounds that includes a tertiary alcohols, 2-methyl-3-octyn-2-ol (16R), 3-methyl-1-octyn-3-ol (23C) and 3,5-dimethyl-1-hexyn-3-ol (23E). The graph shows unexpected improvement in selectivity for all three alcohols where concentration of the alcohols is around 0.2 wt%; and
FIG. 6 illustrates process selectivity for depositing TaN on Cu and SiO₂ wherein passivation formulation includes 2-octyne (1V) with primary alcohol, 2-octyn-1-ol (120) (0.1 and 1 wt%), and 2-octyne (1V) with primary alcohol, 2-octyn-1-ol (120) (0.1 wt%) and tertiary alcohol, 2-methyl-3-octyn-2-ol (16R). The graph shows unexpected improvement in selectivity for the acetylenic compound that includes a tertiary alcohol, while no improvement was observed for formulation including only primary acetylenic alcohol.

### DETAILED DESCRIPTION

All references, including publications, patent applications, and patents, cited herein are hereby incorporated by reference to the same extent as if each reference were individually and specifically indicated to be incorporated by reference and were set forth in its entirety herein.

The use of the terms "a" and "an" and "the" and similar referents in the context of describing the disclosed and claimed subject matter (especially in the context of the following claims) are to be construed to cover both the singular and the plural, unless otherwise indicated herein or clearly contradicted by context. The terms "comprising," "having," "including," and "containing" are to be construed as open-ended terms (*i.e*., meaning "including, but not limited to,") unless otherwise noted. Recitation of ranges of values herein are merely intended to serve as a shorthand method of referring individually to each separate value falling within the range, unless otherwise indicated herein, and each separate value is incorporated into the specification as if it were individually recited herein. All methods described herein can be performed in any suitable order unless otherwise indicated herein or otherwise clearly contradicted by context. The use of any and all examples, or exemplary language (*e.g*., "such as") provided herein, is intended merely to better illuminate the disclosed and claimed subject matter and does not pose a limitation on the scope of the disclosed and claimed subject matter unless otherwise claimed. No language in the specification should be construed as indicating any non-claimed element as essential to the practice of the disclosed and claimed subject matter. The use of the term "comprising" or "including" in the specification and the claims includes the narrower language of "consisting essentially of" and "consisting of."

Embodiments of the disclosed and claimed subject matter are described herein, including the best mode known to the inventors for carrying out the disclosed and claimed subject matter. Variations of those embodiments may become apparent to those of ordinary skill in the art upon reading the foregoing description. The inventors expect skilled artisans to employ such variations as appropriate, and the inventors intend for the disclosed and claimed subject matter to be practiced otherwise than as specifically described herein. Accordingly, the disclosed and claimed subject matter includes all modifications and equivalents of the subject matter recited in the claims appended hereto as permitted by applicable law. Moreover, any combination of the above-described elements in all possible variations thereof is encompassed by the disclosed and claimed subject matter unless otherwise indicated herein or otherwise clearly contradicted by context.

It will be understood that the term "silicon" as deposited as a material on a microelectronic device will include polysilicon.

For ease of reference, "microelectronic device" or "semiconductor device" corresponds to semiconductor wafers having integrated circuits, memory, and other electronic structures fabricated thereon, and flat panel displays, phase change memory devices, solar panels and other products including solar substrates, photovoltaics, and microelectromechanical systems (MEMS), manufactured for use in microelectronic, integrated circuit, or computer chip applications. Solar substrates include, but are not limited to, silicon, amorphous silicon, polycrystalline silicon, monocrystalline silicon, CdTe, copper indium selenide, copper indium sulfide, and gallium arsenide on gallium. The solar substrates may be doped or undoped. It is to be understood that the term "microelectronic device" or "semiconductor device" is not meant to be limiting in any way and includes any substrate that will eventually become a microelectronic device or microelectronic assembly.

As defined herein, the term "barrier material" corresponds to any material used in the art to seal the metal lines, *e.g*., copper interconnects, to minimize the diffusion of said metal, *e.g*., copper, into the dielectric material. Preferred barrier layer materials include tantalum, titanium, ruthenium, hafnium, and other refractory metals and their nitrides and silicides.

"Substantially free" is defined herein as less than 0.001 *wt*%. "Substantially free" also includes 0.000 *wt*%. The term "free of" means 0.000 *wt%*. As used herein, "about" or "approximately" are intended to correspond to within ± 5% of the stated value.

"Alkylene" means a linear saturated divalent hydrocarbon radical of one to six carbon atoms or a branched saturated divalent hydrocarbon radical of three to six carbon atoms unless otherwise stated (*e.g*., methylene, ethylene, propylene, 1-methylpropylene, 2-methylpropylene, butylene, pentylene and the like).

"Heteroalkylene" means an -(alkylene)- radical as defined above where one, two or three carbons in the alkylene chain is replaced by -O-, N(H, alkyl, or substituted alkyl), S, SO, SO₂, or CO. In some preferred embodiments, the carbons are replaced by O or N.

In all such compositions, wherein specific components of the composition are discussed in reference to weight percentage (or "weight %") ranges including a zero lower limit, it will be understood that such components may be present or absent in various specific embodiments of the composition, and that in instances where such components are present, they may be present at concentrations as low as 0.001 weight percent, based on the total weight of the composition in which such components are employed. Note all percentages of the components are weight percentages and are based on the total weight of the composition, that is, 100%. Any reference to "one or more" or "at least one" includes "two or more" and "three or more" and so on.

Where applicable, all weight percents unless otherwise indicated are "neat" meaning that they do not include the aqueous solution in which they are present when added to the composition. For example, "neat" refers to the weight % amount of an undiluted acid or other material (*i.e*., the inclusion 100 g of 85% phosphoric acid constitutes 85 g of the acid and 15 grams of diluent).

Moreover, when referring to the compositions described herein in terms of weight % ("wt%"), it is understood that in no event shall the wt% of all components, including non-essential components, such as impurities, add to more than 100 wt%. In compositions "consisting essentially of" recited components, such components may add up to 100 wt% of the composition or may add up to less than 100 wt%. Where the components add up to less than 100 wt%, such composition may include some small amounts of a non-essential contaminants or impurities. For example, in one such embodiment, the formulation can contain 2 wt% or less of impurities. In another embodiment, the formulation can contain 1 wt% or less than of impurities. In a further embodiment, the formulation can contain 0.05 wt% or less than of impurities. In other such embodiments, the constituents can form at least 90 wt%, more preferably at least 95 wt%, more preferably at least 99 wt%, more preferably at least 99.5 wt%, most preferably at least 99.9 wt%, and can include other ingredients that do not material affect the performance of the formulation. Otherwise, if no significant non-essential impurity component is present, it is understood that the composition of all essential constituent components will essentially add up to 100 wt%.

The headings employed herein are not intended to be limiting; rather, they are included for organizational purposes only.

As noted above, the disclosed and claimed subject matter relates to formulations that include (i) one or more alkynes in combination with (ii) one or more tertiary alcohols as well as their use for enhanced passivation of metallic substrates. These unique formulations have been designed to specifically address shortcomings and exigencies in deposition processes utilizing alkynes. In particular, it has been discovered that the alkynes can readily passivate metallic surfaces that are free or substantially free of hydroxyl groups by strong adsorption on "naked" metallic surface. For example, it has been shown that the alkynes strongly adsorb on a "naked" copper surface with an adsorption energy of -40 to -45 kcal/mol. On the other hand, this behavior was at best inconsistent on partially hydroxylated metallic surfaces; for example, it was also observed that an unsubstituted alkyne did not adsorb well on metallic surfaces terminated with -OH or M-O-M bonds, such as copper(I) oxide or tungsten or molybdenum surfaces. Thus, while it is possible to utilize the alkynes on "naked" metallic surfaces, most metal surfaces include residual oxides that would require further processing to render them freely reactive.

### Disclosed and Claimed Formulations

Given the forgoing, in one embodiment the disclosed and claimed subject relates to formulations that include, consist essentially of and/or consist of (i) one or more alkynes in combination and (ii) one or more tertiary alcohols. These formulations are particularly well-suited for performing enhanced passivation of metallic substrates. In one embodiment, the formulation includes, consists essentially of or consists of (ii) one or more tertiary alcohols that is an acetylenic compound that includes a tertiary alcohol. In another aspect of this embodiment, the difference between boiling point of the tertiary alcohol and boiling point of alkyne is < 50 °C.

Specific aspects of the disclosed and claimed subject matter are exemplified below.

### (i) Alkynes

As discussed above, the disclosed and claimed subject matter relates to formulations that include (i) one or more alkynes. The alkynes are preferably of high purity. Preferred alkynes include those exemplified in Tables 1-3. It is to be understood, however, that the (i) one or more alkynes are not limited to the to those exemplified in Tables 1-3.

**Table 1**

| **Alkyne Structure** | **Alkyne Structure** | **Alkyne Structure** |
|---|---|---|
| 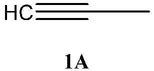 | 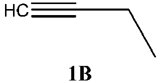 | 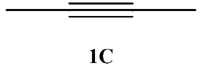 |
| 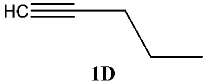 | 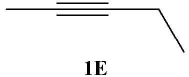 | 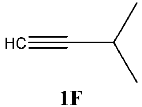 |
| 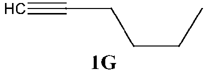 | 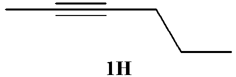 | 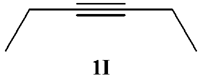 |
| 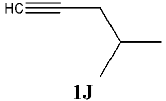 | 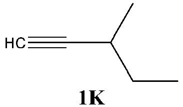 | 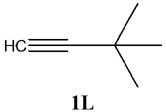 |
| 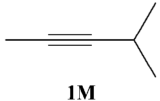 | 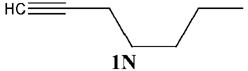 | 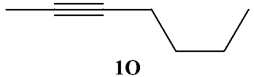 |
| 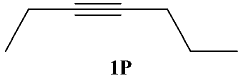 | 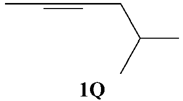 | 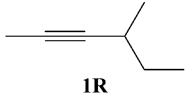 |
| 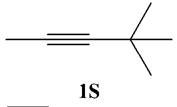 | 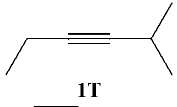 | 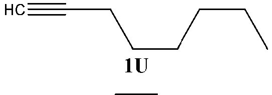 |
| 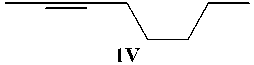 | 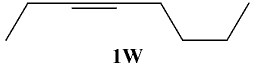 | 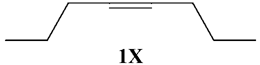 |

**Table 2**

| **Alkyne Structure** | **Alkyne Structure** | **Alkyne Structure** |
|---|---|---|
| 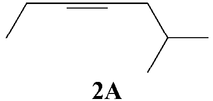 | 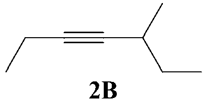 | 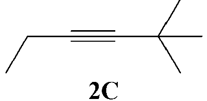 |
| 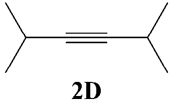 | 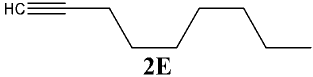 | 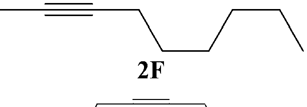 |
| 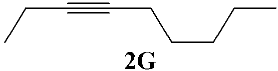 | 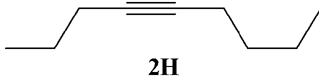 | 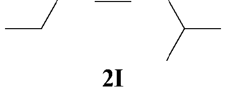 |
| 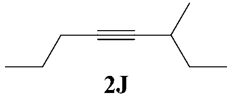 | 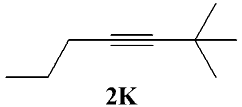 | 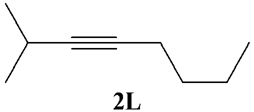 |
| 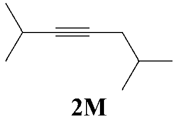 | 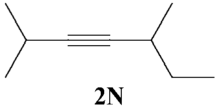 | 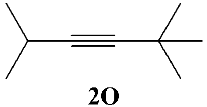 |

**Table 3**

| **Alkyne Structure** | **Alkyne Structure** | **Alkyne Structure** |
|---|---|---|
| 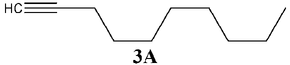 | 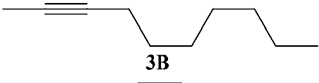 | 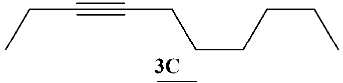 |
| 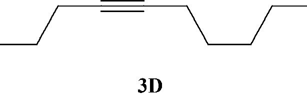 | 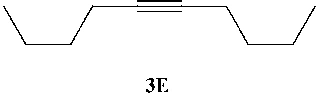 | 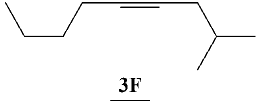 |
| 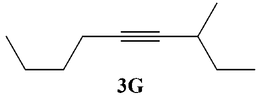 | 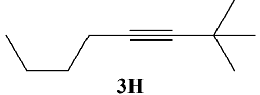 | 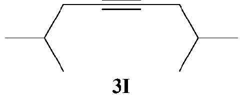 |
| 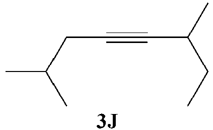 | 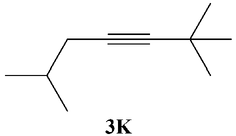 | 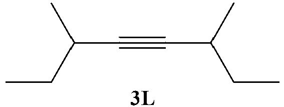 |
| 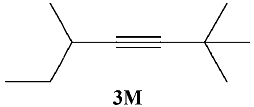 | 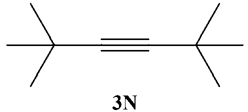 | 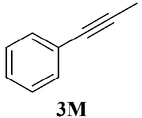 |

The alkynes of the disclosed and claimed subject matter are not limited to those exemplified in Tables 1-3.

In one embodiment, the (i) one or more alkynes includes 5-decyne (3E).

In one embodiment, the (i) one or more alkynes consists essentially of 5-decyne (3E).

In one embodiment, the (i) one or more alkynes consists of 5-decyne (3E).

In one embodiment, the formulations include (i) two or more alkynes. In one aspect of this embodiment, one of the two or more alkynes is 5-decyne (3E).

In one embodiment, the formulations include at least about 95 wt% of alkyne. In a further aspect of this embodiment, the formulations include at least about 99 wt% of alkyne. In a further aspect of this embodiment, the formulations include at least about 99.5 wt% of alkyne.

In one embodiment, the (i) one or more alkynes is a high purity alkyne that is substantially free of water. In one aspect of this embodiment, the (i) one or more high purity alkyne has a residual concentration of water of less than about 500 ppm. In one aspect of this embodiment, the (i) one or more high purity alkyne has a residual concentration of water of less than about 100 ppm. In one aspect of this embodiment, the (i) one or more high purity alkyne has a residual concentration of water of less than about 50 ppm. In one aspect of this embodiment, the (i) one or more high purity alkyne has a residual concentration of water of less than about 25 ppm. In one aspect of this embodiment, the (i) one or more high purity alkyne has a residual concentration of water of less than about 10 ppm. In one aspect of this embodiment, the (i) one or more high purity alkyne is free of detectable water. In one aspect of this embodiment, the (i) one or more high purity alkyne is free of water.

In one embodiment, the (i) one or more alkynes is a high purity alkyne that is substantially free of carboxylic acids. In one aspect of this embodiment, the (i) one or more high purity alkyne has a residual concentration of carboxylic acids in high purity alkyne is less than about 1000 ppm. In one aspect of this embodiment, the (i) one or more high purity alkyne has a residual concentration of carboxylic acids in high purity alkyne is less than about 500 ppm. In one aspect of this embodiment, the (i) one or more high purity alkyne has a residual concentration of carboxylic acids in high purity alkyne is less than about 100 ppm. In one aspect of this embodiment, the (i) one or more high purity alkyne is free of detectable carboxylic acids. In one aspect of this embodiment, the (i) one or more high purity alkyne is free of carboxylic acids.

In one embodiment, the (i) one or more alkynes is a high purity alkyne that is substantially free of impurities which may react with metallic surface during a passivation process. In one embodiment, the (i) one or more high purity alkyne is substantially free of impurities that react with precursors during a deposition process.

In one embodiment, the (i) one or more alkynes is a high purity alkyne that is substantially free of impurities that passivate non-metallic surface and suppress growth on non-metallic surface.

In one embodiment, the (i) one or more alkynes is a high purity alkyne that is substantially free of halogen-containing impurities. In one aspect of this embodiment, the halogen-containing impurities are one or more of a fluorohydrocarbon, a chlorohydrocarbon, a bromohydrocarbon and an iodohydrocarbon. In one aspect of this embodiment, the (i) one or more high purity alkyne has a residual concentration of halogen-containing impurities of less than about 1000 ppm. In one aspect of this embodiment, the (i) one or more high purity alkyne has a residual concentration of halogen-containing impurities of less than about 500 ppm. In one aspect of this embodiment, the (i) one or more high purity alkyne has a residual concentration of halogen-containing impurities of less than about 100 ppm. In one aspect of this embodiment, the (i) one or more high purity alkyne has a residual concentration of halogen-containing impurities of less than about 50 ppm. In one aspect of this embodiment, the (i) one or more high purity alkyne has a residual concentration of halogen-containing impurities of less than about 10 ppm. In one aspect of this embodiment, the (i) one or more high purity alkyne is free of halogen-containing impurities. In the forgoing aspects, the residual concentration of halogen-containing impurities is detected by one or more of GC-ICP-MS, GC-FID, GC-ECD, and GC-MS.

In one embodiment, the (i) one or more alkynes is a high purity alkyne that is purified by adsorption on alumina. In one aspect of this embodiment the alkyne is passed via adsorption bed packed with acidic alumina. In another aspect of this embodiment, the alkyne is passed via adsorption bed packed with neutral alumina. In another aspect of this embodiment the alkyne is passed via adsorption bed packed with basic alumina. In another aspect of this embodiment the alkyne is passed via adsorption bed including a combination of acidic, basic and neutral alumina.

In one embodiment, the (i) one or more alkynes is a high purity alkyne that is purified by exposure to molecular sieves. In one embodiment, the (i) one or more high purity alkyne is purified by exposure to silica gel. In one embodiment, the (i) one or more high purity alkyne is purified by exposure to one or more adsorbent materials.

In one embodiment, the (i) one or more alkynes is a high purity alkyne that is purified by treatment with one or more group (I) metal followed by a distillation process. In one aspect of this embodiment, the alkyne is treated with metallic sodium. In another aspect embodiment, the metal and the alkyne are separated by filtration and the alkyne is distilled to remove non-volatile products of the reaction of impurities with metals.

In one embodiment, the (i) one or more alkynes is a high purity alkyne that is purified by treatment with one or more group (II) metal hydride followed by a distillation process. In one aspect of this embodiment, the alkyne is treated with calcium hydride. In another aspect embodiment, the metal hydride and the alkyne are separated by filtration and the alkyne is distilled to remove non-volatile products of the reaction of impurities with metals.

In one embodiment, the (i) one or more alkynes is a high purity alkyne that is purified by exposure to activated carbon. In one aspect of this embodiment the alkyne is separated by filtration and is distilled to remove non-volatile products after treatment with activated carbon.

### (ii) Tertiary Alcohol

As discussed above, the disclosed and claimed subject matter relates to formulations that include (ii) one or more tertiary alcohols. Preferred tertiary alcohols include acetylenic compound that includes a tertiary alcohol. In some embodiments, the acetylenic compound that includes a tertiary alcohol have Formula 1: 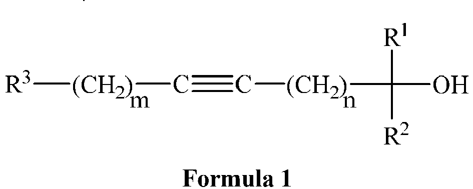 where (i) m = 0-3, (ii) n = 0-3, (iii) R³ is a hydrogen, a linear C₁-C₈ alkyl group, a branched C₃-C₈ alkyl group, a cyclic C₃-C₈ alkyl group, a five-member aromatic ring or a six-member aromatic ring and (iv) each of R¹ and R² is independently a linear C₁-C₈ alkyl group or a branched C₃-C₈ alkyl group.

In one embodiment, m = 0 in Formula 1.

In one embodiment, m = 1 in Formula 1.

In one embodiment, m = 2 in Formula 1.

In one embodiment, m = 3 in Formula 1.

In one embodiment, n = 0 in Formula 1.

In one embodiment, n = 1 in Formula 1.

In one embodiment, n = 2 in Formula 1.

In one embodiment, n = 3 in Formula 1.

In one embodiment, m = n = 0 in Formula 1.

In one embodiment, m = n = 1 in Formula 1.

In one embodiment, m = n = 2 in Formula 1.

In one embodiment, m = n = 3 in Formula 1.

In one embodiment, m = n in Formula 1.

In one embodiment, m ≠ n in Formula 1.

In one embodiment, R³ is a hydrogen in Formula 1.

In one embodiment, R³ is a methyl group in Formula 1.

In one embodiment, R³ is a phenyl group in Formula 1.

In one embodiment, one of R¹ and R² is a methyl group in Formula 1.

In one embodiment, each of R¹ and R² is a methyl group in Formula 1.

Preferred acetylenic compound that includes a tertiary alcohol, including those having Formula 1, are exemplified in Table 4. It is to be understood, however, that the (ii) one or more tertiary alcohols is not limited to those exemplified in Table 4.

**Table 4**

| **Alcohol Structure** | **Alcohol Structure** | **Alcohol Structure** | |
|---|---|---|---|
| 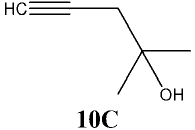 | 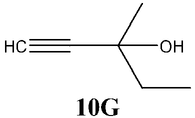 | 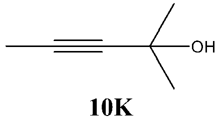 | |
| 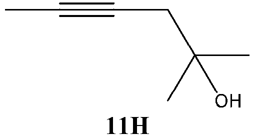 | 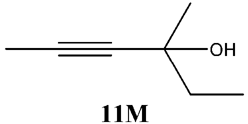 | 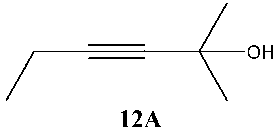 | |
| 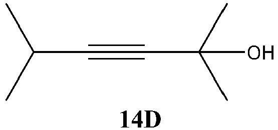 | 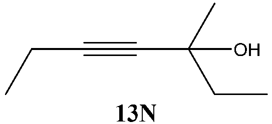 | 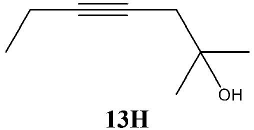 | |
| 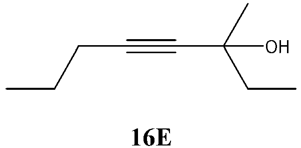 | 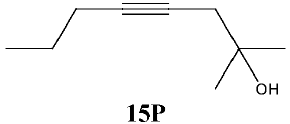 | 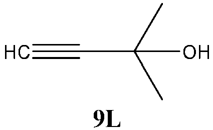 | |
| 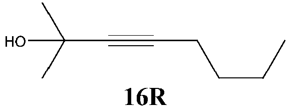 | 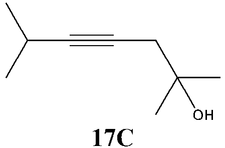 | 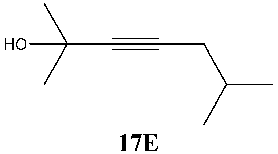 | |
| 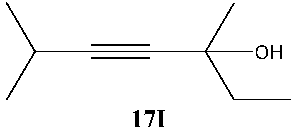 | 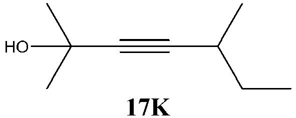 | | 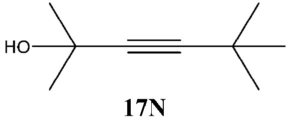 |
| 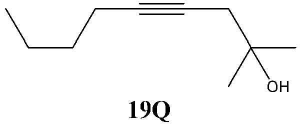 | 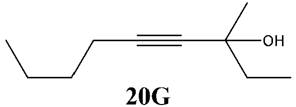 | | 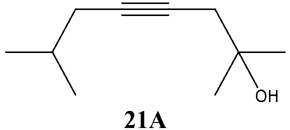 |
| 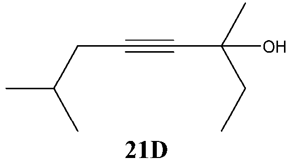 | 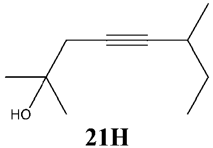 | | 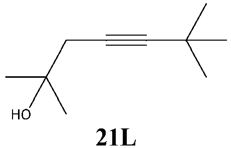 |
| 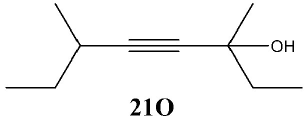 | 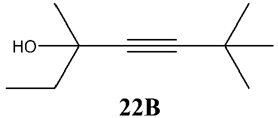 | | 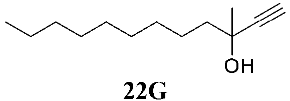 |
| 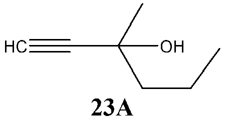 | 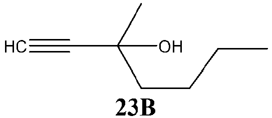 | | 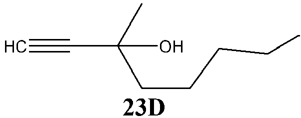 |
| 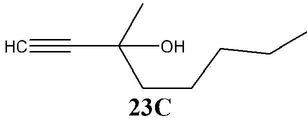 | 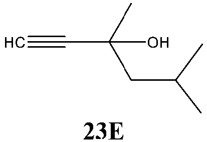 | | 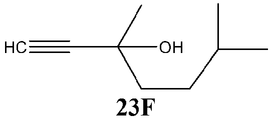 |
| 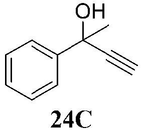 | | 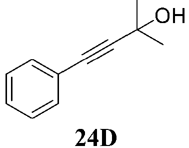 | |

**Table 5: Comparative Acetylenic Compounds with Primary Alcohols**

| **Alcohol Structure** | **Alcohol Structure** |
|---|---|
| 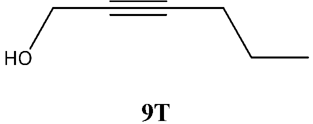 | 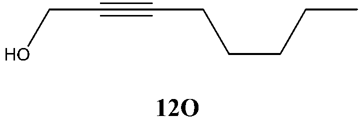 |

In one embodiment, the (ii) one or more tertiary alcohols includes 2-methyloct-3-yn-2-ol (16R).

In one embodiment, the (ii) one or more tertiary alcohols consists essentially of 2-methyloct-3-yn-2-ol (16R).

In one embodiment, the (ii) one or more tertiary alcohols consists of 2-methyloct-3-yn-2-ol (16R).

In one embodiment, the (ii) one or more tertiary alcohols includes 3,5-dimethyl-1-hexyn-3-ol (23E).

In one embodiment, the (ii) one or more tertiary alcohols consists essentially of 3,5-dimethyl-1-hexyn-3-ol (23E).

In one embodiment, the (ii) one or more tertiary alcohols consists of 3,5-dimethyl-1-hexyn-3-ol (23E).

In one embodiment, the (ii) one or more tertiary alcohols includes 3-methyl-1-octyn-3-ol (23C).

In one embodiment, the (ii) one or more tertiary alcohols consists essentially of 3-methyl-1-octyn-3-ol (23C).

In one embodiment, the (ii) one or more tertiary alcohols consists of 3-methyl-1-octyn-3-ol (23C).

In one embodiment, the formulations include at least about 100 ppm (0.01 wt%) of the (ii) one or more tertiary alcohols. In one embodiment, the formulations include at least about 200 ppm (0.02 wt%) of the (ii) one or more tertiary alcohols. In one embodiment, the formulations include at least about 250 ppm (0.025 wt%) of the (ii) one or more tertiary alcohols. In one embodiment, the formulations include at least about 500 ppm (0.05 wt%) of the (ii) one or more tertiary alcohols. In one embodiment, the formulations include at least about 750 ppm (0.075 wt%) of the (ii) one or more tertiary alcohols. In one embodiment, the formulations include at least about 1000 ppm (0.1 wt%) of the (ii) one or more tertiary alcohols. In one embodiment, the formulations include at least about 1500 ppm (0.15 wt%) of the (ii) one or more tertiary alcohols. In one embodiment, the formulations include at least about 2000 ppm (0.20 wt%) of the (ii) one or more tertiary alcohols. In one embodiment, the formulations include at least about 2500 ppm (0.25 wt%) of the (ii) one or more tertiary alcohols. In one embodiment, the formulations include at least about 5000 ppm (0.50 wt%) of the (ii) one or more tertiary alcohols. In one embodiment, the formulations include at least about 7500 ppm (0.75 wt%) of the (ii) one or more tertiary alcohols. In one embodiment, the formulations include at least about 10,000 ppm (1.0 wt%) of the (ii) one or more tertiary alcohols. In one embodiment, the formulations include at least about 15,000 ppm (1.5 wt%) of the (ii) one or more tertiary alcohols. In one embodiment, the formulations include at least about 20,000 ppm (2 wt%) of the (ii) one or more tertiary alcohols.

In one embodiment, the formulations include about 0.01 wt% to about 2 wt% of the (ii) one or more tertiary alcohols. In one embodiment, the formulations include about 0.02 wt% to about 2 wt% of the (ii) one or more tertiary alcohols. In one embodiment, the formulations include about 0.05 wt% to about 2 wt% of the (ii) one or more tertiary alcohols. In one embodiment, the formulations include about 0.1 wt% to about 2 wt% of the (ii) one or more tertiary alcohols. In one embodiment, the formulations include about 0.2 wt% to about 2 wt% of the (ii) one or more tertiary alcohols. In one embodiment, the formulations include about 0.05 wt% to about 0.5 wt% of the (ii) one or more tertiary alcohols.

In one embodiment, the formulations include (ii) two or more tertiary alcohols. In one aspect of this embodiment, one or more of the two or more tertiary alcohols is an acetylenic compound that includes a tertiary alcohol. In one aspect of this embodiment, the two or more tertiary alcohols are acetylenic compounds that each includes a tertiary alcohol.

### Exemplary Formulations

In one embodiment, the disclosed and claimed formulations include, consist essentially of or consist of:
(i) one or more alkynes that includes one or more of 5-decyne (3E) and 3-hexyne (1I); and
(ii) one or more tertiary alcohols.

In one aspect of this embodiment, the (ii) one or more tertiary alcohols selected from the group of 2-methyloct-3-yn-2-ol (16R), 3,5-dimethyl-1-hexyn-3-ol (23E) and 3-methyl-1-octyn-3-ol (23C). In one aspect of this embodiment, the (ii) one or more tertiary alcohols includes 2-methyloct-3-yn-2-ol (16R). In one aspect of this embodiment, the (ii) one or more tertiary alcohols includes 3,5-dimethyl-1-hexyn-3-ol (23E). In one aspect of this embodiment, the (ii) one or more tertiary alcohols includes 3-methyl-1-octyn-3-ol (23C).

In another aspect of this embodiment, the (i) one or more alkynes is a high-purity alkyne.

In another aspect of this embodiment, the (i) one or more alkynes includes 3-hexyne (1I).

In another aspect of this embodiment, the (i) one or more alkynes consists essentially of 3-hexyne (1I).

In another aspect of this embodiment, the (i) one or more alkynes consists of 3-hexyne (1I).

In another aspect of this embodiment, the (i) one or more alkynes includes at least about 95 wt% of 3-hexyne (1I).

In another aspect of this embodiment, the (i) one or more alkynes includes at least about 99 wt% of 3-hexyne (1I).

In another aspect of this embodiment, the (i) one or more alkynes includes at least about 99.5 wt% of 3-hexyne (1I).

In another aspect of this embodiment, the (i) one or more alkynes includes 5-decyne (3E).

In another aspect of this embodiment, the (i) one or more alkynes consists essentially of 5-decyne (3E).

In another aspect of this embodiment, the (i) one or more alkynes consists of 5-decyne (3E).

In another aspect of this embodiment, the (i) one or more alkynes includes at least about 95 wt% of 5-decyne (3E).

In another aspect of this embodiment, the (i) one or more alkynes includes at least about 99 wt% of 5-decyne (3E).

In another aspect of this embodiment, the (i) one or more alkynes includes at least about 99.5 wt% of 5-decyne (3E).

In another aspect of this embodiment, the (i) one or more alkynes includes both 5-decyne (3E) and 3-hexyne (1I).

In another aspect of this embodiment, the (i) one or more alkynes includes at least about 95 wt% of 5-decyne (3E) and 3-hexyne (1I).

In another aspect of this embodiment, the (i) one or more alkynes includes at least about 99 wt% of 5-decyne (3E) and 3-hexyne (1I).

In another aspect of this embodiment, the (i) one or more alkynes includes at least about 99.5 wt% of 5-decyne (3E) and 3-hexyne (1I).

In one embodiment, the disclosed and claimed formulations include, consist essentially of or consist of:
(i) one or more alkynes that includes 3-hexyne (1I); and
(ii) one or more tertiary alcohols selected from the group of 2-methyloct-3-yn-2-ol (16R), 3,5-dimethyl-1-hexyn-3-ol (23E) and 3-methyl-1-octyn-3-ol (23C).
In one aspect of this embodiment, the (ii) one or more tertiary alcohols includes 2-methyloct-3-yn-2-ol (16R). In one aspect of this embodiment, the (ii) one or more tertiary alcohols includes 3,5-dimethyl-1-hexyn-3-ol (23E). In one aspect of this embodiment, the (ii) one or more tertiary alcohols includes 3-methyl-1-octyn-3-ol (23C).

In another aspect of this embodiment, the (i) one or more alkynes that includes 3-hexyne (1I) is a high-purity alkyne. In a further aspect, the 3-hexyne (1I) is high purity.

In another aspect of this embodiment, the (i) one or more high-purity alkyne consists essentially of 3-hexyne (1I). In a further aspect, the 3-hexyne (1I) is high purity.

In another aspect of this embodiment, the (i) one or more alkynes consists of 3-hexyne (1I). In a further aspect, the 3-hexyne (1I) is high purity.

In another aspect of this embodiment, the (i) one or more alkynes includes at least about 95 wt% of 3-hexyne (1I). In a further aspect, the 3-hexyne (1I) is high purity.

In another aspect of this embodiment, the (i) one or more alkynes includes at least about 99 wt% of 3-hexyne (1I). In a further aspect, the 3-hexyne (1I) is high purity.

In another aspect of this embodiment, the (i) one or more alkynes includes at least about 99.5 wt% of 3-hexyne (1I). In a further aspect, the 3-hexyne (1I) is high purity.

In another aspect of this embodiment, the formulations include at least about 100 ppm of the (ii) one or more tertiary alcohols selected from the group of 2-methyloct-3-yn-2-ol (16R), 3,5-dimethyl-1-hexyn-3-ol (23E) and 3-methyl-1-octyn-3-ol (23C).

In another aspect of this embodiment, the formulations include at least about 250 ppm of the (ii) one or more tertiary alcohols selected from the group of 2-methyloct-3-yn-2-ol (16R), 3,5-dimethyl-1-hexyn-3-ol (23E) and 3-methyl-1-octyn-3-ol (23C).

In another aspect of this embodiment, the formulations include at least about 500 ppm of the (ii) one or more tertiary alcohols selected from the group of 2-methyloct-3-yn-2-ol (16R), 3,5-dimethyl-1-hexyn-3-ol (23E) and 3-methyl-1-octyn-3-ol (23C).

In another aspect of this embodiment, the formulations include at least about 750 ppm of the (ii) one or more tertiary alcohols selected from the group of 2-methyloct-3-yn-2-ol (16R), 3,5-dimethyl-1-hexyn-3-ol (23E) and 3-methyl-1-octyn-3-ol (23C).

In another aspect of this embodiment, the formulations include at least about 1000 ppm of the (ii) one or more tertiary alcohols selected from the group of 2-methyloct-3-yn-2-ol (16R), 3,5-dimethyl-1-hexyn-3-ol (23E) and 3-methyl-1-octyn-3-ol (23C).

In one embodiment, the disclosed and claimed formulations include, consist essentially of or consist of:
(i) one or more alkynes that includes 5-decyne (3E); and
(ii) one or more tertiary alcohols selected from the group of 2-methyloct-3-yn-2-ol (16R), 3,5-dimethyl-1-hexyn-3-ol (23E) and 3-methyl-1-octyn-3-ol (23C).
In one aspect of this embodiment, the (ii) one or more tertiary alcohols includes 2-methyloct-3-yn-2-ol (16R). In one aspect of this embodiment, the (ii) one or more tertiary alcohols includes ,5-dimethyl-1-hexyn-3-ol (23E). In one aspect of this embodiment, the (ii) one or more tertiary alcohols includes 3-methyl-1-octyn-3-ol (23C).

In another aspect of this embodiment, the (i) one or more alkynes that includes 5-decyne (3E) is a high-purity alkyne. In a further aspect, the 5-decyne (3E) is high purity.

In another aspect of this embodiment, the (i) one or more alkynes consists essentially of 5-decyne (3E). In a further aspect, the 5-decyne (3E) is high purity.

In another aspect of this embodiment, the (i) one or more alkynes consists of 5-decyne (3E). In a further aspect, the 5-decyne (3E) is high purity.

In another aspect of this embodiment, the (i) one or more alkynes includes at least about 95 wt% of 5-decyne (3E). In a further aspect, the 5-decyne (3E) is high purity.

In another aspect of this embodiment, the (i) one or more alkynes includes at least about 99 wt% of 5-decyne (3E). In a further aspect, the 5-decyne (3E) is high purity.

In another aspect of this embodiment, the (i) one or more alkynes includes at least about 99.5 wt% of 5-decyne (3E). In a further aspect, the 5-decyne (3E) is high purity.

In one embodiment, the formulations include about 0.01 wt% to about 2 wt% of the (ii) one or more tertiary alcohols selected from the group of 2-methyloct-3-yn-2-ol (16R), 3,5-dimethyl-1-hexyn-3-ol (23E) and 3-methyl-1-octyn-3-ol (23C).

In another aspect of this embodiment, the formulations include at least about 100 ppm of the (ii) one or more tertiary alcohols selected from the group of 2-methyloct-3-yn-2-ol (16R), 3,5-dimethyl-1-hexyn-3-ol (23E) and 3-methyl-1-octyn-3-ol (23C).

In another aspect of this embodiment, the formulations include at least about 250 ppm of the (ii) one or more tertiary alcohols selected from the group of 2-methyloct-3-yn-2-ol (16R), 3,5-dimethyl-1-hexyn-3-ol (23E) and 3-methyl-1-octyn-3-ol (23C).

In another aspect of this embodiment, the formulations include at least about 500 ppm of the (ii) one or more tertiary alcohols selected from the group of 2-methyloct-3-yn-2-ol (16R), 3,5-dimethyl-1-hexyn-3-ol (23E) and 3-methyl-1-octyn-3-ol (23C).

In another aspect of this embodiment, the formulations include at least about 750 ppm of the (ii) one or more tertiary alcohols selected from the group of 2-methyloct-3-yn-2-ol (16R), 3,5-dimethyl-1-hexyn-3-ol (23E) and 3-methyl-1-octyn-3-ol (23C).

In another aspect of this embodiment, the formulations include at least about 1000 ppm of the (ii) one or more tertiary alcohols selected from the group of 2-methyloct-3-yn-2-ol (16R), 3,5-dimethyl-1-hexyn-3-ol (23E) and 3-methyl-1-octyn-3-ol (23C).

In one embodiment, the disclosed and claimed formulations include, consist essentially of or consist of:
(i) one or more alkynes that includes one or more of 5-decyne (3E) and 1-decyne (3A); and
(ii) one or more tertiary alcohols.
In one aspect of this embodiment, the (ii) one or more tertiary alcohols is selected from the group of 2-methyloct-3-yn-2-ol (16R), 3,5-dimethyl-1-hexyn-3-ol (23E) and 3-methyl-1-octyn-3-ol (23C). In one aspect of this embodiment, the (ii) one or more tertiary alcohols includes 2-methyloct-3-yn-2-ol (16R). In one aspect of this embodiment, the (ii) one or more tertiary alcohols includes 3,5-dimethyl-1-hexyn-3-ol (23E). In one aspect of this embodiment, the (ii) one or more tertiary alcohols includes 3-methyl-1-octyn-3-ol (23C).

In another aspect of this embodiment, the (i) one or more alkynes is a high-purity alkyne.

In another aspect of this embodiment, the (i) one or more alkynes includes 1-decyne (3A).

In another aspect of this embodiment, the (i) one or more alkynes consists essentially of 1-decyne (3A).

In another aspect of this embodiment, the (i) one or more alkynes consists of 1-decyne (3A).

In another aspect of this embodiment, the (i) one or more alkynes includes at least about 95 wt% of 1-decyne (3A).

In another aspect of this embodiment, the (i) one or more alkynes includes at least about 99 wt% of 1-decyne (3A).

In another aspect of this embodiment, the (i) one or more alkynes includes at least about 99.5 wt% of 1-decyne (3A).

In another aspect of this embodiment, the (i) one or more alkynes includes both 5-decyne (3E) and 1-decyne (3A).

In another aspect of this embodiment, the (i) one or more alkynes includes at least about 95 wt% of 5-decyne (3E) and 1-decyne (3A).

In another aspect of this embodiment, the (i) one or more alkynes includes at least about 99 wt% of 5-decyne (3E) and 1-decyne (3A).

In another aspect of this embodiment, the (i) one or more alkynes includes at least about 99.5 wt% of 5-decyne (3E) and 1-decyne (3A).

In another aspect of this embodiment, the formulations include at least about 100 ppm of the (ii) one or more tertiary alcohols selected from the group of 2-methyloct-3-yn-2-ol (16R), 3,5-dimethyl-1-hexyn-3-ol (23E) and 3-methyl-1-octyn-3-ol (23C).

In another aspect of this embodiment, the formulations include at least about 250 ppm of the (ii) one or more tertiary alcohols selected from the group of 2-methyloct-3-yn-2-ol (16R), 3,5-dimethyl-1-hexyn-3-ol (23E) and 3-methyl-1-octyn-3-ol (23C).

In another aspect of this embodiment, the formulations include at least about 500 ppm of the (ii) one or more tertiary alcohols selected from the group of 2-methyloct-3-yn-2-ol (16R), 3,5-dimethyl-1-hexyn-3-ol (23E) and 3-methyl-1-octyn-3-ol (23C).

In another aspect of this embodiment, the formulations include at least about 750 ppm of the (ii) one or more tertiary alcohols selected from the group of 2-methyloct-3-yn-2-ol (16R), 3,5-dimethyl-1-hexyn-3-ol (23E) and 3-methyl-1-octyn-3-ol (23C).

In another aspect of this embodiment, the formulations include at least about 1000 ppm of the (ii) one or more tertiary alcohols selected from the group of 2-methyloct-3-yn-2-ol (16R), 3,5-dimethyl-1-hexyn-3-ol (23E) and 3-methyl-1-octyn-3-ol (23C).

In one embodiment, the disclosed and claimed formulations include, consist essentially of or consist of:
(i) one or more alkynes that includes 1-decyne (3A); and
(ii) one or more tertiary alcohols selected from the group of 2-methyloct-3-yn-2-ol (16R), 3,5-dimethyl-1-hexyn-3-ol (23E) and 3-methyl-1-octyn-3-ol (23C).
In one aspect of this embodiment, the (ii) one or more tertiary alcohols includes 2-methyloct-3-yn-2-ol (16R). In one aspect of this embodiment, the (ii) one or more tertiary alcohols includes ,5-dimethyl-1-hexyn-3-ol (23E). In one aspect of this embodiment, the (ii) one or more tertiary alcohols includes 3-methyl-1-octyn-3-ol (23C).

In another aspect of this embodiment, the (i) one or more alkynes that includes 1-decyne (3A) is a high-purity alkyne. In a further aspect, the 5-decyne (3E) is high purity.

In another aspect of this embodiment, the (i) one or more alkynes consists essentially of 1-decyne (3A). In a further aspect, the 1-decyne (3A) is high purity.

In another aspect of this embodiment, the (i) one or more alkynes consists of 1-decyne (3A). In a further aspect, the 5-decyne (3E) is high purity.

In another aspect of this embodiment, the (i) one or more alkynes includes at least about 95 wt% of 1-decyne (3A). In a further aspect, the 1-decyne (3A) is high purity.

In another aspect of this embodiment, the (i) one or more alkynes includes at least about 99 wt% of 1-decyne (3A). In a further aspect, the 1-decyne (3A) is high purity.

In another aspect of this embodiment, the (i) one or more alkynes includes at least about 99.5 wt% of 1-decyne (3A). In a further aspect, the 1-decyne (3A) is high purity.

In one embodiment, the formulations include about 0.01 wt% to about 2 wt% of the (ii) one or more tertiary alcohols selected from the group of 2-methyloct-3-yn-2-ol (16R), 3,5-dimethyl-1-hexyn-3-ol (23E) and 3-methyl-1-octyn-3-ol (23C).

In another aspect of this embodiment, the formulations include at least about 100 ppm of the (ii) one or more tertiary alcohols selected from the group of 2-methyloct-3-yn-2-ol (16R), 3,5-dimethyl-1-hexyn-3-ol (23E) and 3-methyl-1-octyn-3-ol (23C).

In another aspect of this embodiment, the formulations include at least about 250 ppm of the (ii) one or more tertiary alcohols selected from the group of 2-methyloct-3-yn-2-ol (16R), 3,5-dimethyl-1-hexyn-3-ol (23E) and 3-methyl-1-octyn-3-ol (23C).

In another aspect of this embodiment, the formulations include at least about 500 ppm of the (ii) one or more tertiary alcohols selected from the group of 2-methyloct-3-yn-2-ol (16R), 3,5-dimethyl-1-hexyn-3-ol (23E) and 3-methyl-1-octyn-3-ol (23C).

In another aspect of this embodiment, the formulations include at least about 750 ppm of the (ii) one or more tertiary alcohols selected from the group of 2-methyloct-3-yn-2-ol (16R), 3,5-dimethyl-1-hexyn-3-ol (23E) and 3-methyl-1-octyn-3-ol (23C).

In another aspect of this embodiment, the formulations include at least about 1000 ppm of the (ii) one or more tertiary alcohols selected from the group of 2-methyloct-3-yn-2-ol (16R), 3,5-dimethyl-1-hexyn-3-ol (23E) and 3-methyl-1-octyn-3-ol (23C).

In one embodiment, the disclosed and claimed formulations include, consist essentially of or consist of:
(i) one or more alkynes that includes one or more of 5-decyne (3E), 1-decyne (3A) and 3-hexyne (1I); and
(ii) one or more tertiary alcohols.

In one aspect of this embodiment, the (ii) one or more tertiary alcohols selected from the group of 2-methyloct-3-yn-2-ol (16R), 3,5-dimethyl-1-hexyn-3-ol (23E) and 3-methyl-1-octyn-3-ol (23C). In one aspect of this embodiment, the (ii) one or more tertiary alcohols includes 2-methyloct-3-yn-2-ol (16R). In one aspect of this embodiment, the (ii) one or more tertiary alcohols includes 3,5-dimethyl-1-hexyn-3-ol (23E). In one aspect of this embodiment, the (ii) one or more tertiary alcohols includes 3-methyl-1-octyn-3-ol (23C).

### Methods of Use

The disclosed and claimed subject matter further includes the use of the disclosed and claimed formulations in chemical vapor deposition process known to those of skill in the art. As used herein, the term "chemical vapor deposition process" refers to any process wherein a substrate is exposed to one or more volatile precursors, which react and/or decompose on the substrate surface to produce the desired deposition.

In one embodiment, the method includes the use of disclosed and claimed formulations to passivate metallic surfaces of the substrate and inhibit growth of oxide or nitride films on metallic surfaces in film deposition steps conducted after surface passivation. Metallic surfaces may include, but are not limited to Au, Pd, Rh, Ru, W, Mo, Al, Ni, Cu, Ti, Co, Pt and metal silicides (e.g., TiSi₂, CoSi₂, and NiSi₂). Metal nitride films deposited on pre-passivated metallic substrate may include but are not limited to TaN, TiN, WN, MoN, TaCN, TiCN, TaSiN, and TiSiN, and silicon nitride. Metal oxide films deposited on pre-passivated metallic substrate may include but are not limited to SiO₂, SiON, HfO₂, Ta₂O₅, ZrO₂, TiO₂, Al₂O₃, barium strontium titanate and combinations thereof.

When utilized in such deposition methods and processes claimed formulations may be delivered to the reaction chamber such as an ALD reactor in a variety of ways. In some instances, a liquid delivery system may be utilized. In other instances, a combined liquid delivery and flash vaporization process unit may be employed, such as, for example, the turbo vaporizer manufactured by MSP Corporation of Shoreview, MN, to enable low volatility materials to be volumetrically delivered, which leads to reproducible transport and deposition without thermal decomposition of the precursor. The claimed formulations described herein can be effectively used as source reagents via direct liquid injection (DLI) to provide a vapor stream of these metal precursors into an ALD reactor.

When used in these processes, claimed formulations can be combined with and include hydrocarbon solvents which are particularly desirable due to their ability to be dried to sub-ppm levels of water. Exemplary hydrocarbon solvents that can be used in the precursors include, but are not limited to, toluene, mesitylene, cumene (isopropylbenzene), *p*-cymene (4-isopropyl toluene), 1,3-diisopropylbenzene, octane, dodecane, 1,2,4-trimethylcyclohexane, *n-*butylcyclohexane, and decahydronaphthalene (decalin). In certain embodiments, the hydrocarbon solvent is a high boiling point solvent or has a boiling point of 100 °C or greater.

A flow of argon and/or other gas may be employed as a carrier gas to help deliver a vapor containing claimed formulations to the reaction chamber during the formulation pulsing. When delivering the formulations, the reaction chamber process pressure is between 1 and 100 torr, preferably between 5 and 20 torr.

Substrate temperature can be an important process variable in the passivation of metal-containing films. Typical substrate temperatures range from about 150 °C to about 350 °C.

In one embodiment, the disclosed and claimed subject matter includes a method for treatment a metallic surface in the presence of at least one other surface that includes the steps of:
a. providing the at least one surface of the substrate in a reaction vessel;
b. forming at least one passivated surface by exposing the at least one surface to one or more of the disclosed and claimed formulations.
In step (b) the at least one surface is passivated by exposing the at least one surface to one or more of the disclosed and claimed formulations to form a passivating film on the at least one surface. In a further aspect of this embodiment, the method includes depositing a nitride film on the at least one passivated surface. In a further aspect of this embodiment, the method includes depositing an oxide film on the at least one passivated surface.

In one embodiment, the method includes depositing one or more precursors known in the art as a film on the passivating film using an atomic layer deposition process (ALD), including plasma-enhanced ALD (PEALD). As used herein, the term "atomic layer deposition process" or ALD refers to a self-limiting (e.g., the amount of film material deposited in each reaction cycle is constant), sequential surface chemistry that deposits films of materials onto substrates of varying compositions. Although the precursors, reagents and sources used herein may be sometimes described as "gaseous," it is understood that the precursors can be either liquid or solid which are transported with or without an inert gas into the reactor via direct vaporization, bubbling or sublimation. In some case, the vaporized precursors can pass through a plasma generator. The term "reactor" as used herein, includes without limitation, reaction chamber, reaction vessel or deposition chamber.

In a further aspect of this embodiment, the method includes introducing at least one reactant into the reaction vessel where the at least one reactant is selected from the group of water, diatomic oxygen, oxygen plasma, ozone, NO, N₂O, NO₂, carbon monoxide, carbon dioxide and combinations thereof. In another aspect of this embodiment, the method includes introducing at least one reactant into the reaction vessel where the at least one reactant is selected from the group of ammonia, hydrazine, monoalkylhydrazine, dialkylhydrazine, nitrogen, nitrogen/hydrogen, ammonia plasma, nitrogen plasma, nitrogen/hydrogen plasma, and combinations thereof. In another aspect of this embodiment, the method includes introducing at least one reactant into the reaction vessel where the at least one reactant is selected from the group of hydrogen, hydrogen plasma, a mixture of hydrogen and helium, a mixture of hydrogen and argon, hydrogen/helium plasma, hydrogen/argon plasma, boron-containing compounds, silicon-containing compounds and combinations thereof.

The deposition methods and processes may also involve one or more purge gases. The purge gas, which is used to purge away unconsumed reactants and/or reaction byproducts, is an inert gas that does not react with the precursors. Exemplary purge gases include, but are not limited to, argon (Ar), nitrogen (N₂), helium (He), neon, and mixtures thereof. For example, a purge gas such as Ar is supplied into the reactor at a flow rate ranging from about 10 to about 2000 sccm for about 0.1 to 10,000 seconds, thereby purging the unreacted material and any byproduct that may remain in the reactor.

The deposition methods and processes require that energy be applied to the at least one of the precursors, oxidizing agent, other precursors or combination thereof to induce reaction and to form the metal-containing film or coating on the substrate. Such energy can be provided by, but not limited to, thermal, plasma, pulsed plasma, helicon plasma, high density plasma, inductively coupled plasma, X-ray, electron beam (e-beam), photon, remote plasma methods, and combinations thereof. In some processes, a secondary RF-frequency source can be used to modify the plasma characteristics at the substrate surface. When utilizing plasma, the plasma-generated process may include a direct plasma-generated process in which plasma is directly generated in the reactor, or alternatively a remote plasma-generated process in which plasma is generated outside of the reactor and supplied into the reactor.

When utilized in such deposition methods and processes suitable precursors may be delivered to the reaction chamber such as an ALD reactor in a variety of ways. In some instances, a liquid delivery system may be utilized. In other instances, a combined liquid delivery and flash vaporization process unit may be employed, such as, for example, the turbo vaporizer manufactured by MSP Corporation of Shoreview, MN, to enable low volatility materials to be volumetrically delivered, which leads to reproducible transport and deposition without thermal decomposition of the precursor. The precursor compositions described herein can be effectively used as source reagents via direct liquid injection (DLI) to provide a vapor stream of these metal precursors into an ALD reactor.

When used in these deposition methods and processes, precursors can be combined with and include hydrocarbon solvents which are particularly desirable due to their ability to be dried to sub-ppm levels of water. Exemplary hydrocarbon solvents that can be used in the precursors include, but are not limited to, toluene, mesitylene, cumene (isopropylbenzene), *p*-cymene (4-isopropyl toluene), 1,3-diisopropylbenzene, octane, dodecane, 1,2,4-trimethylcyclohexane, *n-*butylcyclohexane, and decahydronaphthalene (decalin). In certain embodiments, the hydrocarbon solvent is a high boiling point solvent or has a boiling point of 100 degrees Celsius or greater. The precursors can also be mixed with other suitable metal precursors, and the mixture used to deliver both metals simultaneously for the growth of a binary metal-containing films.

A flow of argon and/or other gas may be employed as a carrier gas to help deliver a vapor containing precursors to the reaction chamber during the precursor pulsing. When delivering the precursors, the reaction chamber process pressure is between 1 and 50 torr, preferably between 5 and 20 torr.

Substrate temperature can be an important process variable in the deposition of high-quality metal-containing films. Typical substrate temperatures range from about 150 °C to about 550 °C. Higher temperatures can promote higher film growth rates.

In view of the forgoing, those skilled in the art will recognize that the disclosed and claimed subject matter further includes the use of the disclosed and claimed formulations in chemical vapor deposition (CVD) processes as follows.

In one embodiment, the disclosed and claimed subject matter includes a method for forming a metal-containing film on at least one surface of a substrate that includes the steps of:
a. providing the at least one surface of a substrate in a reaction vessel;
b. forming at least one passivated surface by exposing the at least one surface to one or more of the disclosed and claimed formulations; and
c. forming a transition metal-containing film on the at least one pre-passivated surface by a chemical vapor deposition (CVD) process using one or more precursors during the deposition process.
In step (b) the at least one surface is passivated by exposing the at least one surface to one or more of the disclosed and claimed formulations to form a passivating film on the at least one surface. In a further aspect of this embodiment, the method includes introducing at least one reactant into the reaction vessel. In a further aspect of this embodiment, the method includes introducing at least one reactant into the reaction vessel where the at least one reactant is selected from the group of water, diatomic oxygen, oxygen plasma, ozone, NO, N₂O, NO₂, carbon monoxide, carbon dioxide and combinations thereof. In another aspect of this embodiment, the method includes introducing at least one reactant into the reaction vessel where the at least one reactant is selected from the group of ammonia, hydrazine, monoalkylhydrazine, dialkylhydrazine, nitrogen, nitrogen/hydrogen, ammonia plasma, nitrogen plasma, nitrogen/hydrogen plasma, and combinations thereof. In another aspect of this embodiment, the method includes introducing at least one reactant into the reaction vessel where the at least one reactant is selected from the group of hydrogen, hydrogen plasma, a mixture of hydrogen and helium, a mixture of hydrogen and argon, hydrogen/helium plasma, hydrogen/argon plasma, boron-containing compounds, silicon-containing compounds and combinations thereof.

In one embodiment, the disclosed and claimed subject matter includes a method of forming a metal-containing film via a thermal atomic layer deposition (ALD) process or thermal ALD-like process that includes the steps of:
a. providing a substrate in a reaction vessel;
b. forming at least one passivated surface by exposing the at least one surface to one or more of the disclosed and claimed formulations;
c. purging the reaction vessel with a first purge gas;
d. introducing into the reaction vessel one or more precursors;
e. introducing into the reaction vessel a source gas;
f. purging the reaction vessel with a second purge gas; and
g. sequentially repeating steps c through f until a desired thickness of the transition metal-containing film is obtained.
In step (b) the at least one surface is passivated by exposing the at least one surface to one or more of the disclosed and claimed formulations to form a passivating film on the at least one surface. In a further aspect of this embodiment, the source gas is one or more of an oxygen-containing source gas selected from water, diatomic oxygen, ozone, NO, N₂O, NO₂, carbon monoxide, carbon dioxide and combinations thereof. In another aspect of this embodiment, the source gas is one or more of a nitrogen-containing source gas selected from ammonia, hydrazine, monoalkylhydrazine, dialkylhydrazine, nitrogen, nitrogen/hydrogen, ammonia plasma, nitrogen plasma, nitrogen/hydrogen plasma and mixture thereof. In a further aspect of this embodiment, the method the first and second purge gases are each independently selected one or more of argon, nitrogen, helium, neon, and combinations thereof. In a further aspect of this embodiment, the method further includes applying energy to the one or more precursor, the source gas, the substrate, and combinations thereof, wherein the energy is one or more of thermal, plasma, pulsed plasma, helicon plasma, high density plasma, inductively coupled plasma, X-ray, e-beam, photon, remote plasma methods and combinations thereof. In a further aspect of this embodiment, step (b) of the method further includes introducing into the reaction vessel one or more of the disclosed and claimed formulations using a stream of carrier gas to deliver a vapor of the one or more of the disclosed and claimed formulations into the reaction vessel. In a further aspect of this embodiment, step b of the method further includes use of a solvent medium including one or more of toluene, mesitylene, isopropylbenzene, 4-isopropyl toluene, 1,3-diisopropylbenzene, octane, dodecane, 1,2,4-trimethylcyclohexane, n-butylcyclohexane, and decahydronaphthalene and combinations thereof.

In one aspect of this disclosure the precursors may be used to co-deposit multi-component oxide films. Multi-component oxide film may include an oxide of two or more elements selected from magnesium, calcium, strontium, barium, aluminum, gallium, indium, titanium, zirconium, hafnium, vanadium, niobium, tantalum, molybdenum, tungsten, tellurium and antimony.

Examples of precursors and co-precursors include but are not limited to trimethylaluminum, *tetrakis*(dimethylamido)titanium, *tetrakis*(ethylmethylamido)zirconium, *tetrakis*(ethylmethylamido)hafnium, *pentakis*(dimethylamido)tantalum and *tris*(isopropylcyclopentadienyl)lanthanum.

The present invention is characterized by the following items:
Item 1: A surface passivating formulation comprising:
(i) one or more alkynes; and
(ii) one or more tertiary alcohols.
Item 2: The formulation of item 1, wherein the (i) one or more alkynes comprises one or more of:

| **Alkyne Structure** | **Alkyne Structure** | **Alkyne Structure** |
|---|---|---|
| 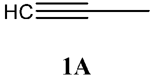 | 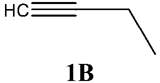 | 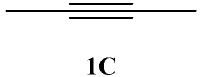 |
| 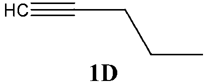 | 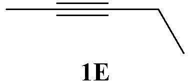 | 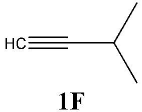 |
| 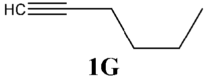 | 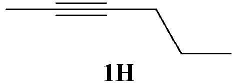 | 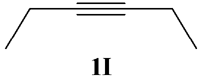 |
| 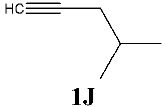 | 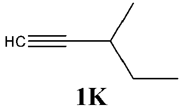 | 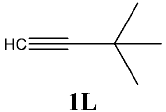 |
| 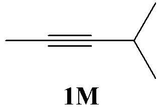 | 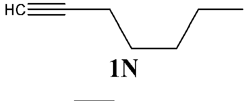 | 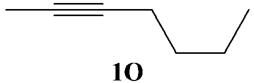 |
| 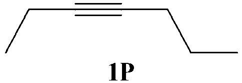 | 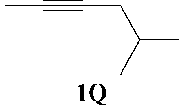 | 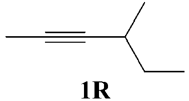 |
| 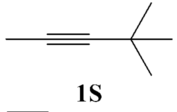 | 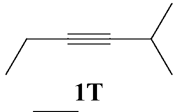 | 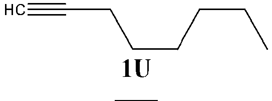 |
| 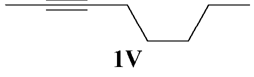 | 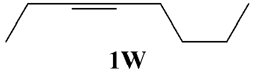 | 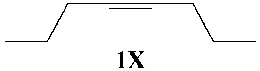 |
| 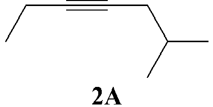 | 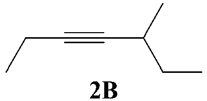 | 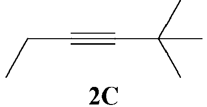 |
| 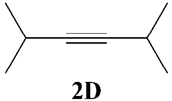 | 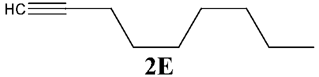 | 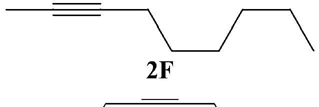 |
| 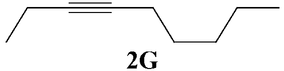 | 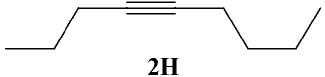 | 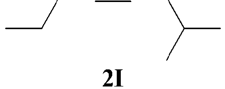 |
| 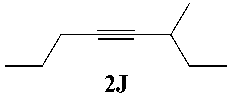 | 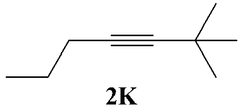 | 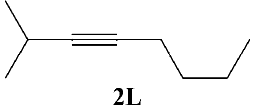 |
| 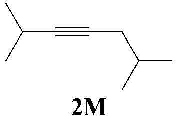 | 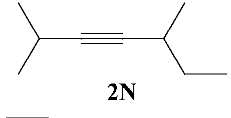 | 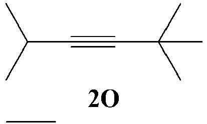 |
| 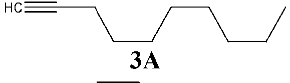 | 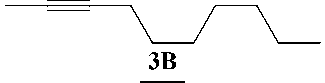 | 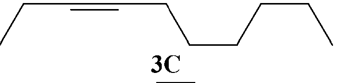 |
| 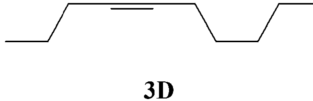 | 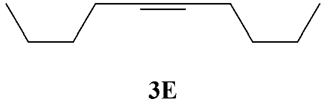 | 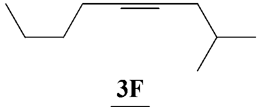 |
| 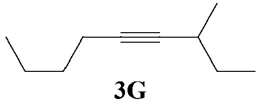 | 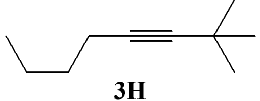 | 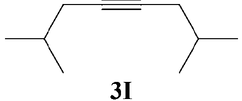 |
| 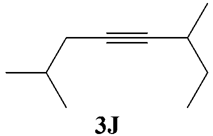 | 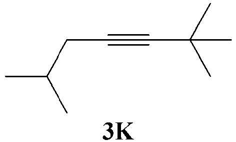 | 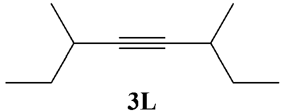 |
| 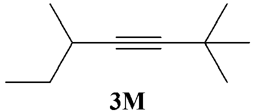 | 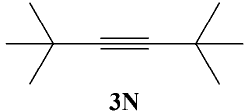 | 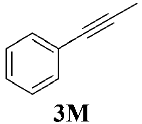 |

Item 3: The formulation of item 1, wherein the (i) one or more alkynes comprises: 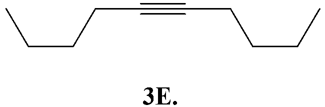 Item 4: The formulation of item 1, wherein the tertiary alcohol comprises one or more one acetylenic compound comprising a tertiary alcohol.
Item 5: The formulation of item 1, wherein the tertiary alcohol comprises one or more one acetylenic compound comprising a tertiary alcohol of Formula1 : 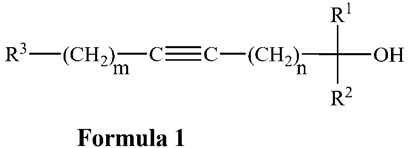 wherein (i) m = 0-3, (ii) n = 0-3, (iii) R³ is a hydrogen, a linear C₁-C₈ alkyl group, a branched C₃-C₈ alkyl group, a cyclic C₃-C₈ alkyl group, a five-member aromatic ring or a six-member aromatic ring and (iv) each of R¹ and R² is independently a linear C₁-C₈ alkyl group or a branched C₃-C₈ alkyl group.
Item 6: The formulation of item 1, wherein m = 0 in Formula 1.
Item 7: The formulation of item 1, wherein m = 1 in Formula 1.
Item 8: The formulation of item 1, wherein m = 2 in Formula 1.
Item 9: The formulation of item 1, wherein m = 3 in Formula 1.
Item 10: The formulation of item 1, wherein n = 0 in Formula 1.
Item 11: The formulation of item 1, wherein n = 1 in Formula 1.
Item 12: The formulation of item 1, wherein n = 2 in Formula 1.
Item 13: The formulation of item 1, wherein n = 3 in Formula 1.
Item 14: The formulation of item 1, wherein m = n = 0 in Formula 1.
Item 15: The formulation of item 1, wherein m = n = 1 in Formula 1.
Item 16: The formulation of item 1, wherein m = n = 2 in Formula 1.
Item 17: The formulation of item 1, wherein m = n = 3 in Formula 1.
Item 18: The formulation of item 1, wherein m = n in Formula 1.
Item 19: The formulation of item 1, wherein m ≠ n in Formula 1.
Item 20: The formulation of item 1, wherein R³ is a hydrogen in Formula 1.
Item 21: The formulation of item 1, wherein R³ is a methyl group in Formula 1.
Item 22: The formulation of item 1, wherein R³ is a phenyl group in Formula 1.
Item 23: The formulation of item 1, wherein one of R¹ and R² is a methyl group in Formula 1.
Item 24: The formulation of item 1, wherein each of R¹ and R² is a methyl group in Formula 1.
Item 25: The formulation of item 1, wherein the tertiary alcohol comprises one or more of:

| **Alcohol Structure** | **Alcohol Structure** | **Alcohol Structure** | |
|---|---|---|---|
| 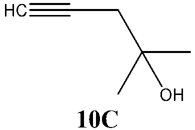 | 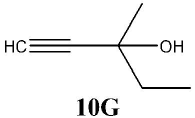 | 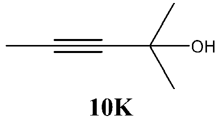 | |
| 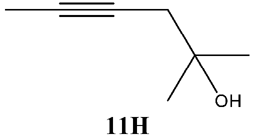 | 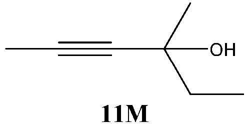 | 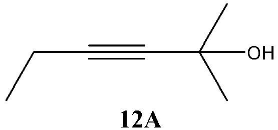 | |
| 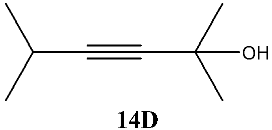 | 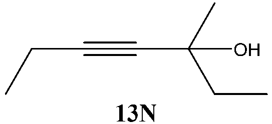 | | 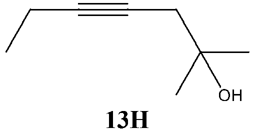 |
| 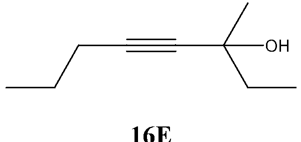 | 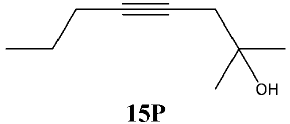 | | 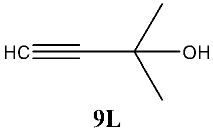 |
| 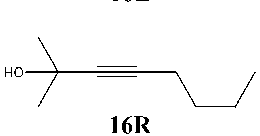 | 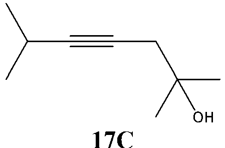 | | 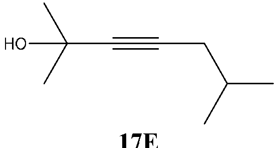 |
| 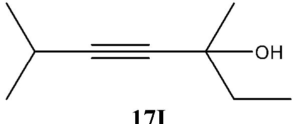 | 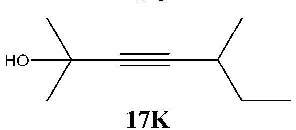 | | 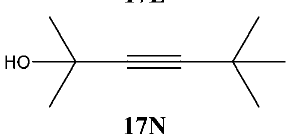 |
| 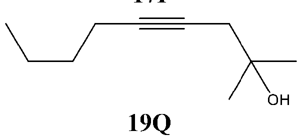 | 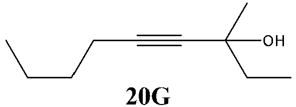 | | 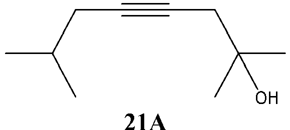 |
| 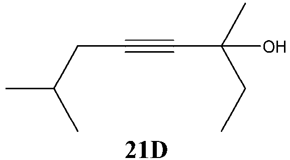 | 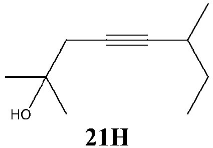 | | 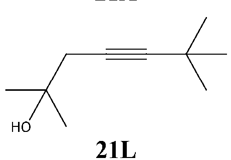 |
| 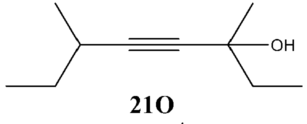 | 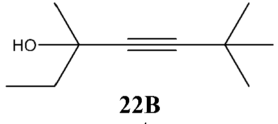 | | 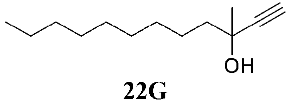 |
| 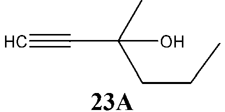 | 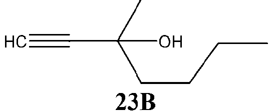 | | 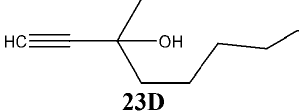 |
| 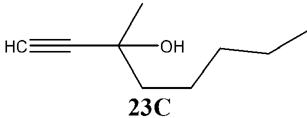 | 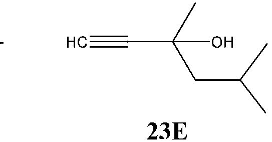 | | 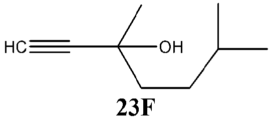 |
| 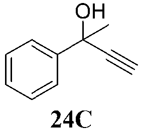 | | 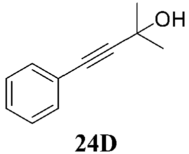 | |

Item 26: The formulation of item 1, wherein the (ii) one or more tertiary alcohol comprises one or more of 2-methyl-3-octyn-2-ol (16R), 3,5-dimethyl-1-hexyn-3-ol (23E) and 3-methyl-1-octyn-3-ol (23C).
Item 27: The formulation of item 1, wherein the (ii) one or more tertiary alcohol comprises 2-methyl-3-octyn-2-ol (16R).
Item 28: The formulation of item 1, wherein the (ii) one or more tertiary alcohol comprises 3,5-dimethyl-1-hexyn-3-ol (23E).
Item 29: The formulation of item 1, wherein the (ii) one or more tertiary alcohol comprises 3-methyl-1-octyn-3-ol (23C).
Item 30: The formulation of item 1, wherein the formulation comprises about 0.01 wt% to about 2 wt% of the (ii) one or more tertiary alcohols.
Item 31: The formulation of item 1, wherein the formulation comprises (ii) two or more tertiary alcohols.
Item 32: The formulation of item 1, wherein the formulation comprises (ii) two or more tertiary alcohols wherein one or more of the two or more tertiary alcohols is an acetylenic compound that includes a tertiary alcohol.
Item 33: The formulation of item 1, wherein the formulation comprises (ii) two or more tertiary alcohols wherein the two or more tertiary alcohols are acetylenic compound that each includes a tertiary alcohol.
Item 34: A surface passivating formulation comprising:
(i) one or more alkynes comprising one or more of 5-decyne (3E), 1-decyne (3A) and 3-hexyne (1I); and
(ii) one or more tertiary alcohol selected from the group of 2-methyl-3-octyn-2-ol (16R), 3,5-dimethyl-1-hexyn-3-ol (23E) and 3-methyl-1-octyn-3-ol (23C).
Item 35: The formulation of item 34, wherein the (i) one or more alkynes comprises 5-decyne (3E) and 3-hexyne (1I).
Item 36: The formulation of item 34, wherein the (i) one or more alkynes comprises at least about 95 wt% of 5-decyne (3E) and 3-hexyne (1I).
Item 37: The formulation of item 34, wherein the (i) one or more alkynes comprises at least about 99 wt% of 5-decyne (3E) and 3-hexyne (1I).
Item 38: The formulation of item 34, wherein the (i) one or more alkynes comprises at least about 99.5 wt% of 5-decyne (3E) and 3-hexyne (1I).
Item 39: The formulation of item 34, wherein the (i) one or more alkynes comprises 5-decyne (3E) and 1-decyne (3A).
Item 40: The formulation of item 34, wherein the (i) one or more alkynes comprises at least about 95 wt% of 5-decyne (3E) and 1-decyne (3A).
Item 41: The formulation of item 34, wherein the (i) one or more alkynes comprises at least about 99 wt% of 5-decyne (3E) and 1-decyne (3A).
Item 42: The formulation of item 34, wherein the (i) one or more alkynes comprises at least about 99.5 wt% of 5-decyne (3E) and 1-decyne (3A).
Item 43: The formulation of item 34, wherein the (i) one or more alkynes comprises 5-decyne (3E).
Item 44: The formulation of item 34, wherein the (i) one or more alkynes comprises at least about 95 wt% of 5-decyne (3E).
Item 45: The formulation of item 34, wherein the (i) one or more alkynes comprises at least about 99 wt% of 5-decyne (3E).
Item 46: The formulation of item 34, wherein the (i) one or more alkynes comprises at least about 99.5 wt% of 5-decyne (3E).
Item 47: The formulation of item 34, wherein the (i) one or more alkynes comprises 3-hexyne (1I).
Item 48: The formulation of item 34, wherein the (i) one or more alkynes comprises at least about 95 wt% of 3-hexyne (1I).
Item 49: The formulation of item 34, wherein the (i) one or more alkynes comprises at least about 99 wt% of 3-hexyne (1I).
Item 50: The formulation of item 34, wherein the (i) one or more alkynes comprises at least about 99.5 wt% of 3-hexyne (1I).
Item 51: The formulation of item 34, wherein the (i) one or more alkynes comprises at least about 95 wt% of 1-decyne (3A).
Item 52: The formulation of item 34, wherein the (i) one or more alkynes comprises at least about 99 wt% of 1-decyne (3A).
Item 53: The formulation of item 34, wherein the (i) one or more alkynes comprises at least about 99.5 wt% of 1-decyne (3A).
Item 54: The formulation of item 34, wherein the (ii) one or more tertiary alcohol comprises 2-methyl-3-octyn-2-ol (16R).
Item 55: The formulation of item 34, wherein the (ii) one or more tertiary alcohol comprises 3,5-dimethyl-1-hexyn-3-ol (23E).
Item 56: The formulation of item 34, wherein the (ii) one or more tertiary alcohol comprises 3-methyl-1-octyn-3-ol (23C).
Item 57: The formulation of item 34, wherein the formulation comprises about 0.01 wt% to about 2 wt% of the (ii) one or more tertiary alcohols selected from the group of 2-methyloct-3-yn-2-ol (16R), 3,5-dimethyl-1-hexyn-3-ol (23E) and 3-methyl-1-octyn-3-ol (23C).
Item 58: The formulation of any of items 1-57, wherein the (i) one or more alkynes comprises one or more high-purity alkyne.
Item 59: The formulation of any of items 1-57, wherein the (i) one or more alkynes comprises one or more high-purity alkyne substantially free of water.
Item 60: The formulation of any of items 1-57, wherein the (i) one or more alkynes comprises one or more high-purity alkyne free of detectable water.
Item 61: The formulation of any of items 1-57, wherein the (i) one or more alkynes comprises one or more high-purity alkyne free of water.
Item 62: The formulation of any of items 1-57, wherein the (i) one or more alkynes comprises one or more high-purity alkyne having a concentration of water of less than about 500 ppm.
Item 63: The formulation of any of items 1-57, wherein the (i) one or more alkynes comprises one or more high-purity alkyne having a concentration of water of less than about 100 ppm.
Item 64: The formulation of any of items 1-57, wherein the (i) one or more alkynes comprises one or more high-purity alkyne having a concentration of water of less than about 50 ppm.
Item 65: The formulation of any of items 1-57, wherein the (i) one or more alkynes comprises one or more high-purity alkyne having a concentration of water of less than about 25 ppm.
Item 66: The formulation of any of items 1-57, wherein the (i) one or more alkynes comprises one or more high-purity alkyne having a concentration of water of less than about 10 ppm.
Item 67: The formulation of any of items 1-57, wherein the (i) one or more alkynes comprises one or more high-purity alkyne substantially free of carboxylic acids.
Item 68: The formulation of any of items 1-57, wherein the (i) one or more alkynes comprises one or more high-purity alkyne free of carboxylic acids.
Item 69: The formulation of any of items 1-57, wherein the (i) one or more alkynes comprises one or more high-purity alkyne free of detectable carboxylic acids.
Item 70: The formulation of any of items 1-57, wherein the (i) one or more alkynes comprises one or more high-purity alkyne having a concentration of carboxylic acids of less than about 1000 ppm.
Item 71: The formulation of any of items 1-57, wherein the (i) one or more alkynes comprises one or more high-purity alkyne having a concentration of carboxylic acids of less than about 500 ppm.
Item 72: The formulation of any of items 1-57, wherein the (i) one or more alkynes comprises one or more high-purity alkyne having a concentration of carboxylic acids of less than about 100 ppm.
Item 73: The formulation of any of items 1-57, wherein the (i) one or more alkynes comprises one or more high-purity alkyne substantially free of halogen-containing impurities.
Item 74: The formulation of any of items 1-57, wherein the (i) one or more alkynes comprises one or more high-purity alkyne free of detectable halogen-containing impurities detected by one or more of GC-ICP-MS, GC-FID, GC-ECD, and GC-MS.
Item 75: The formulation of any of items 1-57, wherein the (i) one or more alkynes comprises one or more high-purity alkyne free of halogen-containing impurities.
Item 76: The formulation of any of items 1-57, wherein the (i) one or more alkynes comprises one or more high-purity alkyne having a concentration of halogen-containing impurities of less than about 1000 ppm.
Item 77: The formulation of any of items 1-57, wherein the (i) one or more alkynes comprises one or more high-purity alkyne having a concentration of halogen-containing impurities of less than about 500 ppm.
Item 78: The formulation of any of items 1-57, wherein the (i) one or more alkynes comprises one or more high-purity alkyne having a concentration of halogen-containing impurities of less than about 100 ppm.
Item 79: The formulation of any of items 1-57, wherein the (i) one or more alkynes comprises one or more high-purity alkyne having a concentration of halogen-containing impurities of less than about 50 ppm.
Item 80: The formulation of any of items 1-57, wherein the (i) one or more alkynes comprises one or more high-purity alkyne having a concentration of halogen-containing impurities of less than about 10 ppm.
Item 81: The formulation of item 73, wherein the halogen-containing impurities are one or more of a fluorohydrocarbon, a chlorohydrocarbon, a bromohydrocarbon and an iodohydrocarbon.
Item 82: A method for forming a film on at least one surface of a substrate comprising:
a. providing the at least one surface of the substrate in a reaction vessel;
b. forming at least one passivated surface by exposing the at least one surface to one or more of the formulations of any of items 1-81.
Item 83: The method of item 82, wherein the method compromises an atomic layer deposition process (ALD).
Item 84: The method of item 82, wherein the method compromises a plasma enhanced ALD (PEALD).
Item 85: The method of item 82, wherein the method compromises a chemical vapor deposition process (CVD).
Item 86: The method of any of items 82, further comprising depositing a nitride film on the at least one passivated surface.
Item 87: The method of any of items 82, further comprising depositing an oxide film on the at least one passivated surface.
Item 88: A method for forming a metal-containing film via a chemical vapor deposition (CVD) process comprising:
**a.** providing the at least one surface of a substrate in a reaction vessel;
**b.** forming at least one passivated surface by exposing the at least one surface to one or more of the formulations of any of items 1-81.
**c.** forming a transition metal-containing film on the at least one pre-passivated surface by a chemical vapor deposition (CVD) process using one or more precursors during the deposition process.
Item 89: The method of item 88, further comprising introducing at least one reactant into the reaction vessel.
Item 90: The method of item 88, further comprising introducing at least one reactant into the reaction vessel selected from the group of water, diatomic oxygen, oxygen plasma, ozone, NO, N₂O, NO₂, carbon monoxide, carbon dioxide and combinations thereof.
Item 91: The method of item 88, further comprising introducing at least one reactant into the reaction vessel selected from the group of ammonia, hydrazine, monoalkylhydrazine, dialkylhydrazine, nitrogen, nitrogen/hydrogen, ammonia plasma, nitrogen plasma, nitrogen/hydrogen plasma, and combinations thereof.
Item 92: The method of item 88, further comprising introducing at least one reactant into the reaction vessel selected from the group of hydrogen, hydrogen plasma, a mixture of hydrogen and helium, a mixture of hydrogen and argon, hydrogen/helium plasma, hydrogen/argon plasma, boron-containing compounds, silicon-containing compounds and combinations thereof.
Item 93: A method for forming a metal-containing film via a thermal atomic layer deposition (ALD) process or thermal ALD-like process comprising:
**a.** providing a substrate in a reaction vessel;
**b.** forming at least one passivated surface by exposing the at least one surface to one or more of the formulations of any of items 1-81.
**c.** purging the reaction vessel with a first purge gas;
**d.** introducing into the reaction vessel one or more precursors;
**e.** introducing into the reaction vessel a source gas;
**f.** purging the reaction vessel with a second purge gas; and
**g.** sequentially repeating steps c through f until a desired thickness of the transition metal-containing film is obtained.
Item 94: The method of item 93, wherein the source gas is one or more of an oxygen-containing source gas selected from water, diatomic oxygen, ozone, NO, N₂O, NO₂, carbon monoxide, carbon dioxide and combinations thereof.
Item 95: The method of item 93, wherein the source gas is one or more of a nitrogen-containing source gas selected from ammonia, hydrazine, monoalkylhydrazine, dialkylhydrazine, nitrogen, nitrogen/hydrogen, ammonia plasma, nitrogen plasma, nitrogen/hydrogen plasma and mixture thereof.
Item 96: The method of item 93, wherein the first purge gas and the second purge gas are each independently selected one or more of argon, nitrogen, helium, neon, and combinations thereof.
Item 97: The method of item 93, further comprising applying energy to the one or more precursor, the source gas, the substrate, and combinations thereof.
Item 98: The method of item 93, further comprising applying energy to the one or more precursor, the source gas, the substrate, and combinations thereof, wherein the energy is one or more of thermal, plasma, pulsed plasma, helicon plasma, high density plasma, inductively coupled plasma, X-ray, e-beam, photon, remote plasma methods and combinations thereof.
Item 99: The method of item 93, wherein step b comprises introducing the one or more formulation into the reaction vessel as vapor using a stream of carrier gas.
Item 100: The method of item 93, wherein step b comprises introducing the one or more formulation using a solvent medium comprising one or more of toluene, mesitylene, isopropylbenzene, 4-isopropyl toluene, 1,3-diisopropylbenzene, octane, dodecane, 1,2,4-trimethylcyclohexane, n-butylcyclohexane, and decahydronaphthalene and combinations thereof.
Item 101: The method of any of items 82-100, further comprising depositing a nitride film on the at least one passivated surface.
Item 102: The method of any of items 82-100, further comprising depositing an oxide film on the at least one passivated surface.
Item 103: The method of any of items 82-100, further comprising depositing a multi-component oxide film on the at least one passivated surface.
Item 104: The method of any of items 82-100, further comprising depositing a multi-component oxide film on the at least one passivated surface, wherein the multi-component oxide film comprises an oxide of two or more elements selected from magnesium, calcium, strontium, barium, aluminum, gallium, indium, titanium, zirconium, hafnium, vanadium, niobium, tantalum, molybdenum, tungsten, tellurium and antimony.
Item 105: The method of any of items 82-100, wherein the one or more precursors comprises trimethylaluminum.
Item 106: The method of any of items 82-100, wherein the one or more precursors comprises tetrakis(dimethylamido)titanium.
Item 107: The method of any of items 82-100, wherein the one or more precursors comprises *tetrakis*(ethylmethylamido)zirconium.
Item 108: The method of any of items 82-100, wherein the one or more precursors comprises *tetrakis*(ethylmethylamido)hafnium.
Item 109: The method of any of items 82-100, wherein the one or more precursors comprises *pentakis*(dimethylamido)tantalum.
Item 110: The method of any of items 82-100, wherein the one or more precursors comprises *tris*(isopropylcyclopentadienyl)lanthanum.

### Examples

Reference will now be made to more specific embodiments of the present disclosure and experimental results that provide support for such embodiments. The examples are given below to more fully illustrate the disclosed and claimed subject matter and should not be construed as limiting the disclosed subject matter in any way.

It will be apparent to those skilled in the art that various modifications and variations can be made in the disclosed subject matter and specific examples provided herein without departing from the spirit or scope of the disclosed subject matter. Thus, it is intended that the disclosed subject matter, including the descriptions provided by the following examples, covers the modifications and variations of the disclosed subject matter that come within the scope of any claims and their equivalents.

### Materials and Methods:

All reactions and manipulations described in the examples were conducted under a nitrogen atmosphere using an inert atmosphere glove box or standard Schlenk techniques. Unless indicated otherwise, all reagents were purchased from MilliporeSigma and were used "as-is" without further purification. Computer simulation program Dmol3 by Biovia with the M11-L/DNP density functional method was used to calculate and study adsorption characteristics of the disclosed and claimed subject matter.

### Specific Examples

The follow abbreviations are used in the various compositions in the tables below:

| **Full name** | **Abbreviation** |
|---|---|
| 5-Decyne | 3E (Alkyne) |
| 3-Hexyne | 1I (Alkyne) |
| 2-methyl-3-octyn-2-ol | 16R (Tertiary Alcohol) |
| 2-Hexyn-1-ol | 9T (Primary Alcohol) |
| 3,5-dimethyl-1-hexyn-3-ol | 23E (Tertiary Alcohol) |
| 3-methyl-1-octyn-3-ol | 23C (Tertiary Alcohol) |
| 2-Octyn-1-ol | 12O (Primary Alcohol) |

### Specific Examples

### Example 1: Adsorption of 5-Decyne on "Naked" Copper Surface

This example evaluated the adsorption of 5-decyne (3E) on "naked" copper surface. It was calculated that 5-decyne strongly chemisorbs on copper (100) surface with an adsorption energy of -43 kcal/mol, and on copper (111) surface with an adsorption energy of -40 kcal/mol.

### Example 2: Adsorption of 5-Decyne (3E) and 16R Alcohol on Copper (I) Oxide

This example evaluated the adsorption of each of 5-decyne (3E) and 2-methyl-3-octyn-2-ol (16R) respectively on hydroxyl rich copper (I) and copper (II) oxide. Copper (I) oxide (Cu₂O) is a common impurity on metallic copper. The result shows that 5-decyne adsorption on hydroxyl rich Cu₂O is weak with adsorption energy only -6.3 kcal/mol. Thus, it is not expected to passivate residual Cu₂O sites on copper surface. Passivation of hydroxyl rich copper(I) surface is important to prevent deposition on this surface. On the other hand, acetylenic 8R alcohol strongly adsorbs on Cu₂O surface. Thus, it is expected to provide much stronger passivation of residual Cu₂O sites on copper surface.

**Table 6**

| **Formulation Component** | **Adsorption Energy (kcal/mol)** | |
|---|---|---|
| | Cu₂O | CuO |
| **5-Decyne** | -6.3 | -15.8 |
| **16R Alcohol** | -20.9 | -26.4 |

### Example 3: Adsorption of 5-Decyne (3E) and 16R Alcohol on Aluminum Oxide

This example evaluated the adsorption of 5-decyne (3E) and 2-methyl-3-octyn-2-ol (16R) on boehmite and gibbsite aluminum oxide. The alcohol has stronger adsorption energy on aluminum oxide compared to copper and copper oxides. Thus, it is expected to passivate aluminum oxide at least partially. Passivation of aluminum oxide is not desirable for selective deposition of films on aluminum oxide vs. metallic surface. Thus, alcohol concentration in the formulation is selected to only block or passivate residual metal oxide sites on metallic surface but not substantially passivate non-metallic surface.

**Table 7**

| **Formulation Component** | **Adsorption Energy (kcal/mol)** | |
|---|---|---|
| | Boehmite | Gibbsite |
| **5-Decyne** | -16.7 | -18.7 |
| **16R Alcohol** | -24.2 | -23.1 |

### Example 4: Adsorption of Methanol (CH₃OH) and 16R Alcohol on Substrates

This example evaluated the adsorption of non-acetylenic alcohol methanol (CH₃OH) and 2-methyl-3-octyn-2-ol (16R) on various substrates. The calculations showed that acetylenic alcohol adsorbs significantly stronger on clean copper surface (-50 *vs.* 13.5 kcal/mol) and on copper oxide (-28.3 *vs.* -2.5 kcal/mol). Thus, formulations containing acetylenic alcohols were shown to provide significantly improved passivation of copper surfaces compared to linear non-acetylenic alcohols.

**Table 8**

| **Adsorption Energy (kcal/mol)** | **Cu(100)** | **Cu₂O** | **CuO** | **Al(O)OH** | **Al(OH)₃** |
|---|---|---|---|---|---|
| **CH₃OH** | -13.5 | -2.5 | -17.7 | -18.7 | -13.1 |
| **16R Alcohol** | -50.0 | -28.3 | -34.4 | -24.2 | -23.1 |

### Example 5: Synthesis of 2-Methyl-3-octyn-2-ol (16R)

235.4 ml of 1.6M solution of *n*-BuLi in hexanes (0.391 mol) were added dropwise at -78 °C to 42.0 ml of 1-hexyne (0.368 mol) in 916 ml of THF. The solution was stirred for one hour. 28.5 ml of acetone (0.388 mol) was added dropwise to the reaction mixture and the mixture was warmed slowly to 0 °C. The mixture was treated with 10 ml of water followed by a solution of 235 g of sodium chloride in 280 g of water. Organic layer was separated from brine solution and dried over 44 g of magnesium sulfate. Solvent was removed from organic fraction to isolate 54.2 g of crude 5-decyn-4-ol (90% yield). Crude 2-methyl-3-octyn-2-ol was purified by fractional distillation at 30 Torr and 85-90 °C to isolate high-purity 2-methyl-3-octyn-2-ol (16R). ¹H NMR (500 MHz, CD₂Cl₂): δ 0.9 (3H, t), 1.40 (2H, m), 1.44 (6H, s), 1.46 (2H, m), 2.17 (2H, t) ppm.

### Example 6: Preparation of High-Purity 5-Decyne (3E)

High-purity 5-decyne that is substantially free from water was prepared by recirculating 3 kg of 5-decyne through a column packed with 300 g of 3Å molecular sieves. Water in 5-decyne before purification was >50 ppm and after purification was 15 ppm, as analyzed by Karl Fisher titration.

### Example 7: High-Purity 5-Decyne (3E) and (16R) Alcohol Formulation

9.0 g of 5-decyne (3E) were mixed with 1.0 g of 16R alcohol. GC-FID shows that the formulation is stable and corresponds to the desired concentration of the alcohol in 5-decyne.

### Example 8: Selectivity of TaN Deposition Using High Purity 5-Decyne (3E) Spiked with 2-Methyl-3-octyn-2-ol (16R)

In this experiment a sample of high purity 5-decyne (99.99 %), a sample of high purity 5-decyne spiked with various concentrations of 16R (0.02 wt%, 0.07 wt%, 0.17 wt%, 0.57 wt%, 1.07 wt%, 2.07 wt% and 5.07 wt%, and a neat 16R were used to study passivation of Cu surface and selective deposition of TaN on SiO₂ and Al₂O₃ relative to Cu surface. High purity 5-decyne was purified by the methods described in Example 6. 16R was prepared by the method described in Example 5.

PVD Cu coupons from ADVACTIV technology were used for the test. Silicon wafers with native silicon oxide (SiO₂) were from Silicon Valley Microelectronics. Al₂O₃ films were deposited by thermal ALD at 250 °C. Cu, SiO₂ and Al₂O₃ coupons were pre-cleaned with 2% citric acid, washed with water, dried, and loaded side-by-side onto a carrier wafer, and transported into reactor chamber. The coupons were pre-cleaned from residual surface oxides by treatment with hydrogen gas at 350 °C for 600 sec at 1.75 torr chamber pressure. After this step the copper coupons were exposed to 5-decyne vapor for 180 seconds at 250 °C. After the exposure the coupons were transferred into another process chamber without air exposure. The coupons were exposed to 25 or 36 ALD cycles to deposit a TaN film. Cycle Conditions: 2 sec of *pentakis*(dimethylamido)tantalum pulse; 20 sec of Ar purge; 7 sec of NH₃ pulse; 20 sec of Ar purge. TaN films were deposited at 250 °C wafer temperature and 1 torr chamber pressure.

The thickness of the TaN film deposited on Cu surface was measured by XPS. The thickness of the TaN film deposited on SiO₂ and Al₂O₃ surface was measured by XRF. The TaN selectivity was calculated by the following formula: Selectivity = (Thickness on SiO₂ - Thickness on Cu)/(Thickness on SiO₂ + Thickness on Cu).

Higher selectivity indicates that thicker film is deposited on the desired substrate (SiO₂ and Al₂O₃) vs. undesired substrate (Cu). Selectivity is summarized in the Tables 9 and 10 and shown on Figures 3 and 4. Selectivity is reduced with larger number # of cycles, as observed in all cases. Surprisingly 5-decyne spiked with 0.07, 0.17, 0.57 and 1.07 wt% of 16R alcohol showed > 10 % improvement in selectivity while neat 16R alcohol and 5-decyne spiked with 2 and 5 wt% of 16R alcohol showed > 10 % reduction in selectivity. Thus, formulations of 5-decyne with > 0.02 wt% but < 2 wt% of acetylenic alcohol, preferably with < 1 wt% of acetylenic alcohol, and more preferably < 0.5 wt% of acetylenic alcohols show significant benefit for selective deposition of TaN.

**Table 9**

| **Formulation** | **TaN Selectivity on SiO₂ vs. Cu** | |
|---|---|---|
| | **25 cycles of TaN** | **36 cycles of TaN** |
| 3E | 0.59 | 0.49 |
| 3E spiked with 0.02 wt% of 16R | 0.58 | 0.46 |
| 3E spiked with 0.07 wt% of 16R | 0.63 | 0.55 |
| 3E spiked with 0.17 wt% of 16R | 0.73 | 0.58 |
| 3E spiked with 0.57 wt% of 16R | 0.67 | 0.53 |
| 3E spiked with 1.07 wt% of 16R | 0.66 | 0.5 |
| 3E spiked with 2.07 wt% of 16R | 0.53 | 0.44 |
| 3E spiked with 5.07 wt% of 16R | 0.39 | 0.35 |
| 16R | 0.49 | 0.42 |

**Table 10**

| **Formulation** | **TaN Selectivity on Al₂O₃ vs. Cu** | |
|---|---|---|
| | **25 cycles of TaN** | **36 cycles of TaN** |
| 3E | 0.32 | 0.29 |
| 3E spiked with 0.02 wt% of 16R | 0.43 | 0.37 |
| 3E spiked with 0.07 wt% of 16R | 0.52 | 0.45 |
| 3E spiked with 0.17 wt% of 16R | 0.50 | 0.42 |
| 3E spiked with 0.57 wt% of 16R | 0.46 | 0.40 |
| 3E spiked with 1.07 wt% of 16R | 0.43 | 0.37 |
| 3E spiked with 2.07 wt% of 16R | 0.26 | 0.28 |
| 3E spiked with 5.07 wt% of 16R | 0.27 | 0.29 |
| 16R | 0.40 | 0.38 |

### Example 9: Selectivity of TaN Deposition Using High Purity 5-Decyne (3E) and 5-Decyne (3E) Spiked with 3,5-Dimethyl-1-hexyn-3-ol (23E)

In this experiment a sample of high purity 5-decyne and a sample of high purity 5-decyne spiked with 0.2 wt% of 23E were used to study passivation of Cu surface and selective deposition of TaN on SiO₂ and Al₂O₃ relative to Cu surface. High purity 5-Decyne was purified by the methods described in the Example 6. 16R was prepared by the method described in Example 5. 23E was purchased from MilliporeSigma and used as is.

PVD Cu coupons from ADVACTIV technology were used for the test. Silicon wafers with native silicon oxide (SiO₂) were from Silicon Valley Microelectronics. Al₂O₃ films were deposited by thermal ALD at 250 °C. Cu, SiO₂ and Al₂O₃ coupons were pre-cleaned with 2% citric acid, washed with water, dried, and loaded side-by-side onto carrier wafer, and transported into reactor chamber. The coupons were pre-cleaned from residual surface oxides by treatment with hydrogen gas at 350 °C for 600 sec at 1.75 torr chamber pressure. After this step the copper coupons were exposed to 5-decyne vapor for 180 seconds at 250 °C. After the exposure the coupons were transferred into another process chamber without air exposure. The coupons were exposed to 25 or 36 ALD cycles to deposit a TaN film. Cycle Conditions: 2 sec of *pentakis*(dimethylamido)tantalum pulse; 20 sec of Ar purge; 7 sec of NH₃ pulse; 20 sec of Ar purge. The TaN films were deposited at 250 °C wafer temperature and 1 torr chamber pressure.

The thickness of the TaN film deposited on Cu surface was measured by XPS. The thickness of TaN film deposited on SiO₂ and Al₂O₃ surface was measured by XRF. The TaN selectivity was calculated by the following formula: Selectivity = (Thickness on SiO₂ - Thickness on Cu)/(Thickness on SiO₂ + Thickness on Cu).

Higher selectivity indicates that thicker film is deposited on the desired substrate (SiO₂ and Al₂O₃) vs. undesired substrate (Cu). Selectivity is summarized in the Tables 11 and 12. Selectivity is reduced with longer # of cycles, as observed in all cases. However, surprisingly 5-decyne spiked with 0.2 wt% of 23E alcohol showed improvement in selectivity.

**Table 11**

| **Formulation** | **TaN Selectivity on SiO₂ vs. Cu** | |
|---|---|---|
| | **25 cycles of TaN** | **36 cycles of TaN** |
| 3E | 0.59 | 0.49 |
| 3E spiked with 0.2 wt% of 23E | 0.70 | 0.58 |

**Table 12**

| **Formulation** | **TaN Selectivity on Al₂O₃ vs. Cu** | |
|---|---|---|
| | **25 cycles of TaN** | **36 cycles of TaN** |
| 3E | 0.32 | 0.29 |
| 3E spiked with 0.2 wt% of 23E | 0.54 | 0.42 |

### Example 10: Selectivity of TaN Deposition Using High Purity 5-Decyne (3E) and 5-Decyne (3E) Spiked with 2-Methyl-3-octyn-2-ol (16R) and 3-Methyl-1-octyn-3-ol (23C)

In this experiment a sample of high purity 5-decyne, a sample of high purity 5-decyne spiked with 0.07 of 16Rand a sample of high purity 5-decyne spiked with 0.07 wt% of 16R and 0.1 wt% of 23C were used to study passivation of Cu surface and selective deposition of TaN on SiO₂ and Al₂O₃ relative to Cu surface. High purity 5-decyne was purified by the methods described in the Examples 6. 16R was prepared by the method described in Example 5. 23C was purchased from BOC Sciences.

PVD Cu coupons from ADVACTIV technology were used for the test. Silicon wafers with native silicon oxide (SiO₂) were from Silicon Valley Microelectronics. Al₂O₃ films were deposited by thermal ALD at 250 °C. Cu, SiO₂ and Al₂O₃ coupons were pre-cleaned with 2% citric acid, washed with water, dried, and loaded side-by-side onto carrier wafer, and transported into reactor chamber. The coupons were pre-cleaned from residual surface oxides by treatment with hydrogen gas at 350 °C for 600 sec at 1.75 torr chamber pressure. After this step the copper coupons were exposed to 5-decyne vapor for 180 seconds at 250 °C. After the exposure the coupons were transferred into another process chamber without air exposure. The coupons were exposed to 25 or 36 ALD cycles to deposit a TaN film. Cycle Conditions: 2 sec of *pentakis*(dimethylamido)tantalum pulse; 20 sec of Ar purge; 7 sec of NH₃ pulse; 20 sec of Ar purge. The TaN films were deposited at 250 °C wafer temperature and 1 torr chamber pressure.

The thickness of the TaN film deposited on Cu surface was measured by XPS. The thickness of the TaN film deposited on SiO₂ and Al₂O₃ surface was measured by XRF. The TaN selectivity was calculated by the following formula: Selectivity = (Thickness on SiO₂ - Thickness on Cu)/(Thickness on SiO₂ + Thickness on Cu).

Higher selectivity indicates that thicker film is deposited on the desired substrate (SiO₂ and Al₂O₃) vs. undesired substrate (Cu). Selectivity is summarized in the Tables 13, 14 and shown in Figure 5. Selectivity is reduced with longer # of cycles, as observed in all cases. However, surprisingly 5-decyne spiked with 0.07 wt% of 16R alcohol and 0.1 wt% of 23C showed > 10 % improvement in selectivity relative to 5-decyne spiked just with 0.07 of 16R. Thus, formulations of 5-decyne containing at least two different acetylenic alcohols, preferably with < 1 wt% of at least two different acetylenic alcohols has substantial benefit for selective deposition of TaN.

**Table 13**

| **Formulation** | **TaN Selectivity on SiO₂ vs. Cu** | |
|---|---|---|
| | **25 cycles of TaN** | **36 cycles of TaN** |
| 3E | 0.59 | 0.49 |
| 3E spiked with 0.07 wt% of 16R | 0.63 | 0.55 |
| 3E spiked with 0.07 of 16R and 0.1 wt% of 23C | 0.75 | 0.60 |

**Table 14**

| **Formulation** | **TaN Selectivity on Al₂O₃ vs. Cu** | |
|---|---|---|
| | **25 cycles of TaN** | **36 cycles of TaN** |
| 3E | 0.32 | 0.29 |
| 3E spiked with 0.07 wt% of 16R | 0.52 | 0.45 |
| 3E spiked with 0.07 wt% of 16R and 0.1 wt% of 23C | 0.71 | 0.57 |

### Example 11: Selectivity of TaN Deposition Using High Purity 5-Decyne (3E) and 5-Decyne (3E) Spiked with 2-Methyl-3-octyn-2-ol (16R) and 1-Decyne (3A)

In this experiment a sample of high purity 5-decyne, a sample of high purity 5-decyne spiked with 0.07 wt% of 16R, and sample of high purity 5-decyne spiked with 0.07 wt% of 16R and 1 wt% of 1-decyne (3A) were used to study passivation of Cu surface and selective deposition of TaN on SiO₂ and Al₂O₃ relative to Cu surface. High purity 5-decyne was purified by the methods described in the Examples 6. 16R was prepared by the method described in Example 5.

PVD Cu coupons from ADVACTIV technology were used for the test. Silicon wafers with native silicon oxide (SiO₂) were from Silicon Valley Microelectronics. Al₂O₃ films were deposited by thermal ALD at 250 °C. Cu, SiO₂ and Al₂O₃ coupons were pre-cleaned with 2% citric acid, washed with water, dried and loaded side-by-side onto carrier wafer, and transported into reactor chamber. The coupons were pre-cleaned from residual surface oxides by treatment with hydrogen gas at 350 °C for 600 sec at 1.75 torr chamber pressure. After this step the copper coupons were exposed to 5-decyne vapor for 180 seconds at 250 °C. After the exposure the coupons were transferred into another process chamber without air exposure. The coupons were exposed to 25 or 36 ALD cycles to deposit a TaN film. Cycle Conditions: 2 sec of *pentakis*(dimethylamido)tantalum pulse; 20 sec of Ar purge; 7 sec of NH₃ pulse; 20 sec of Ar purge. The TaN films were deposited at 250 °C wafer temperature and 1 torr chamber pressure.

The thickness of the TaN film deposited on Cu surface was measured by XPS. The thickness of the TaN film deposited on SiO₂ and Al₂O₃ surface was measured by XRF. The TaN selectivity was calculated by the following formula: Selectivity = (Thickness on SiO₂ - Thickness on Cu)/(Thickness on SiO₂ + Thickness on Cu).

Higher selectivity indicates that thicker film is deposited on desired substrate (SiO₂ and Al₂O₃) vs. undesired substrate (Cu). Selectivity is summarized in the Tables 15 and 16. Selectivity is reduced with longer # of cycles, as observed in all cases. However, surprisingly 5-decyne spiked with 0.07 wt% of 16R alcohol and 1 wt% of 1-decyne (3A) showed > 20% improvement in selectivity relative to high purity 5-decyne or high purity 5-decyne spiked just with 0.07 wt% of 16R.

**Table 15**

| **Formulation** | **TaN Selectivity on SiO₂ vs. Cu** | |
|---|---|---|
| | **25 cycles of TaN** | **36 cycles of TaN** |
| 3E | 0.59 | 0.49 |
| 5-decyne spiked with 0.07 wt% of 16R | 0.63 | 0.55 |
| 5-decyne spiked with 0.07 wt% of 16R and 1 wt% of 1-decyne | 0.8 | 0.73 |

**Table 16**

| **Formulation** | **TaN Selectivity on Al₂O₃ vs. Cu** | |
|---|---|---|
| | **25 cycles of TaN** | **36 cycles of TaN** |
| Neat 5-decyne (3E) | 0.32 | 0.29 |
| 5-decyne spiked with 0.07 wt% of 16R | 0.52 | 0.45 |
| 5-decyne spiked with 0.07 wt% of 16R and 1 wt% of 1-decyne | 0.75 | 0.67 |

### Comparative Example 12: Selectivity of TaN Deposition with 3-Hexyne (11) and 3-Hexyne Spiked with 0.1 and 1 wt% of Primary Acetylenic Alcohol, 2-hexyn-1-ol (9T)

In this experiment a sample of 3-hexyne, a sample of 3-hexyne spiked with 0.1 wt% and 1 wt% of primary acetylenic alcohol (9T) were used to study passivation of Cu surface and selective deposition of TaN on SiO₂ and Al₂O₃ relative to Cu surface. 1I and 9T were purchased from MilliporeSigma.

PVD Cu coupons from ADVACTIV technology were used for the test. Silicon wafers with native silicon oxide (SiO₂) were from Silicon Valley Microelectronics. Al₂O₃ films were deposited by thermal ALD at 250 °C. Cu, SiO₂ and Al₂O₃ coupons were pre-cleaned with 2% citric acid, washed with water, dried and loaded side-by-side onto carrier wafer, and transported into reactor chamber. The coupons were pre-cleaned from residual surface oxides by treatment with hydrogen gas at 350 °C for 600 sec at 1.75 torr chamber pressure. After this step the copper coupons were exposed to 5-decyne vapor for 180 seconds at 250 °C. After the exposure the coupons were transferred into another process chamber without air exposure. The coupons were exposed to 25 or 36 ALD cycles to deposit a TaN film. Cycle Conditions: 2 sec of *pentakis*(dimethylamido)tantalum pulse; 20 sec of Ar purge; 7 sec of NH₃ pulse; 20 sec of Ar purge. The TaN films were deposited at 250 °C wafer temperature and 1 torr chamber pressure.

The thickness of the TaN film deposited on Cu surface was measured by XPS. The thickness of the TaN film deposited on SiO₂ and Al₂O₃ surface was measured by XRF. The TaN selectivity was calculated by the following formula: Selectivity = (Thickness on SiO₂ - Thickness on Cu)/(Thickness on SiO₂ + Thickness on Cu)

Higher selectivity indicates that thicker film is deposited on desired substrate (SiO₂ and Al₂O₃) vs. undesired substrate (Cu). Selectivity is summarized in the Table 17. Selectivity is reduced with longer # of cycles, as observed in all cases. However, surprisingly 3-hexyne spiked with 0.1 and 1 wt% of primary acetylenic alcohol 9T didn't show improvement in selectivity relative to 3-hexyne.

**Table 17**

| **Formulation** | **TaN Selectivity on SiO₂ vs. Cu** | |
|---|---|---|
| | **25 cycles of TaN** | **36 cycles of TaN** |
| 1I | 0.44 | 0.35 |
| *1I* + *0.1 wt% of 9T* | 0.38 | 0.32 |
| *1I + 1 wt% of 9T* | 0.36 | 0.31 |

### Comparative Example 13: Selectivity of TaN Deposition with 2-Octyne (1V) and 2-Octyne Spiked with 0.1 and 1 wt% of Primary Acetylenic Alcohol, 2-Octyn-1-ol (120) and 2-Octyne Spiked with Primary Acetylenic Alcohol (120) and Tertiary Acetylenic Alcohol (16R)

In this experiment a sample of 2-octyne, a sample of 2-octyne spiked with 0.1 *wt*% and 1 wt% of primary acetylenic alcohol (120), and a sample of 2-octyne spiked with 0.1 wt% primary acetylenic alcohol (120) and 0.1 wt% of tertiary acetylenic alcohol (16R), were used to study passivation of Cu surface and selective deposition of TaN on SiO₂ and Al₂O₃ relative to Cu surface. 1I and 9T were purchased from MilliporeSigma.

PVD Cu coupons from ADVACTIV technology were used for the test. Silicon wafers with native silicon oxide (SiO₂) were from Silicon Valley Microelectronics. Al₂O₃ films were deposited by thermal ALD at 250 °C. Cu, SiO₂ and Al₂O₃ coupons were pre-cleaned with 2% citric acid, washed with water, dried and loaded side-by-side onto carrier wafer, and transported into reactor chamber. The coupons were pre-cleaned from residual surface oxides by treatment with hydrogen gas at 350 °C for 600 sec at 1.75 torr chamber pressure. After this step the copper coupons were exposed to 5-decyne vapor for 180 seconds at 250 °C. After the exposure the coupons were transferred into another process chamber without air exposure. The coupons were exposed to 25 or 36 ALD cycles to deposit a TaN film. Cycle Conditions: 2 sec of *pentakis*(dimethylamido)tantalum pulse; 20 sec of Ar purge; 7 sec of NH₃ pulse; 20 sec of Ar purge. TaN films were deposited at 250 °C wafer temperature and 1 torr chamber pressure.

The thickness of the TaN film deposited on Cu surface was measured by XPS. The thickness of TaN film deposited on SiO₂ and Al₂O₃ surface was measured by XRF. The TaN selectivity was calculated by the following formula: Selectivity = (Thickness on SiO₂ - Thickness on Cu)/(Thickness on SiO₂ + Thickness on Cu).

Higher selectivity indicates that thicker film is deposited on desired substrate (SiO₂ and Al₂O₃) vs. undesired substrate (Cu). Selectivity is summarized in the Table 18 and shown in Figure 6. Selectivity is reduced with longer # of cycles, as observed in all cases. However, surprisingly the addition of 0.1 and 1 wt% of primary alcohol (120) to 2-octyne didn't show improvement in selectivity while addition of 0.1 wt% of tertiary alcohol (16R) to the formulation of 2-octyne and 0.1 wt% of 120 showed substantial improvement in process selectivity.

**Table 18**

| **Formulation** | **TaN Selectivity on SiO₂ vs. Cu** | |
|---|---|---|
| | **25 cycles of TaN** | **36 cycles of TaN** |
| 1V | 0.38 | 0.32 |
| 1V + 0.1 wt% of 120 | 0.33 | 0.30 |
| 1V+ 0.1 wt% of 120 and 0.1 wt% of 16R | 0.48 | 0.38 |
| 1V + 1 wt% of 120 | 0.33 | 0.27 |

The foregoing description is intended primarily for purposes of illustration. Although the disclosed and claimed subject matter has been shown and described with respect to an exemplary embodiment thereof, it should be understood by those skilled in the art that the foregoing and various other changes, omissions, and additions in the form and detail thereof may be made therein without departing from the spirit and scope of the disclosed and claimed subject matter.

## Claims

1. A surface passivating formulation comprising:
**(i)** one or more alkynes; and
**(ii)** one or more tertiary alcohols;
wherein the (i) one or more alkynes comprises one or more of:
| **Alkyne Structure** | **Alkyne Structure** | **Alkyne Structure** |
|---|---|---|
| 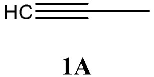 | 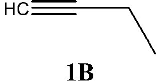 | 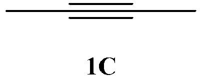 |
| 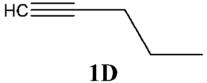 | 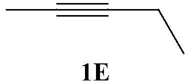 | 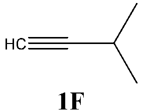 |
| 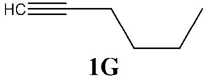 | 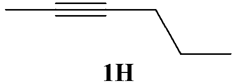 | 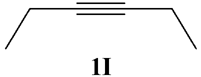 |
| 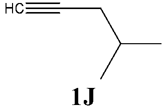 | 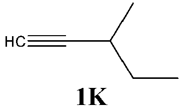 | 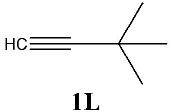 |
| 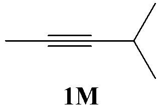 | 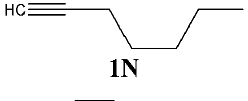 | 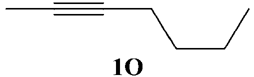 |
| 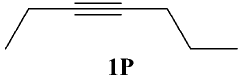 | 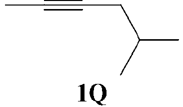 | 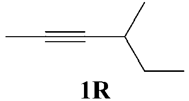 |
| 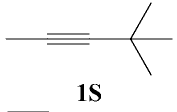 | 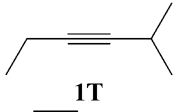 | 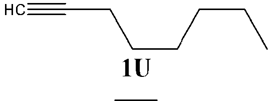 |
| 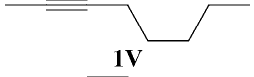 | 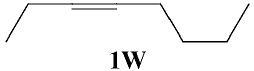 | 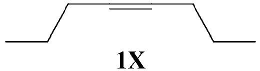 |
| 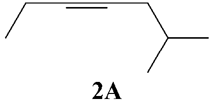 | 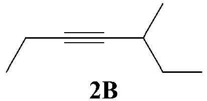 | 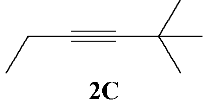 |
| 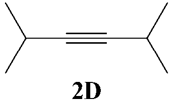 | 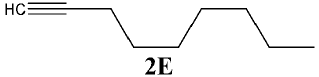 | 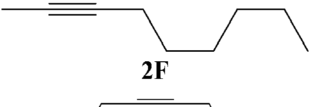 |
| 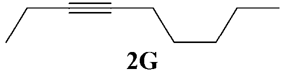 | 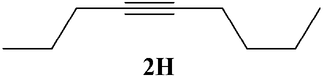 | 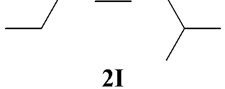 |
| 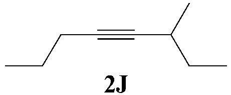 | 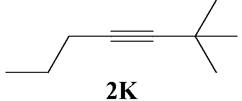 | 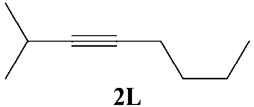 |
| 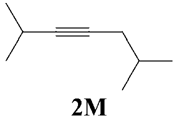 | 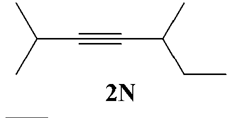 | 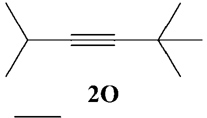 |
| 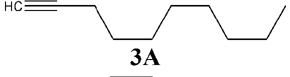 | 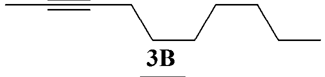 | 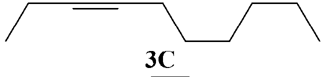 |
| 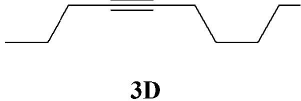 | 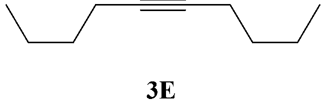 | 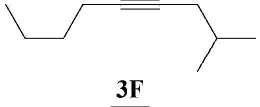 |
| 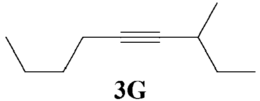 | 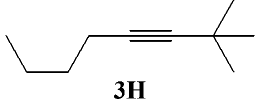 | 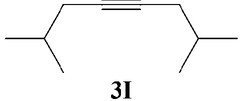 |
| 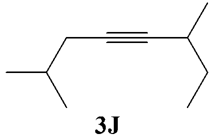 | 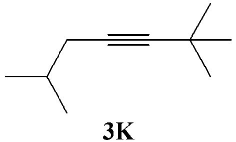 | 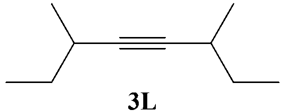 |
| 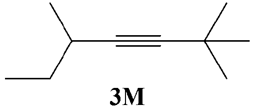 | 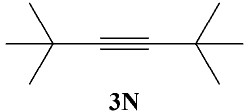 | 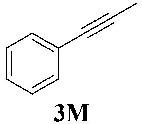 |
wherein alkyne 3E is preferred.

2. The formulation of claim 1, wherein the tertiary alcohol comprises one or more one acetylenic compound comprising a tertiary alcohol.

3. The formulation of claim 1 or 2, wherein the tertiary alcohol comprises one or more one acetylenic compound comprising a tertiary alcohol of Formulal : 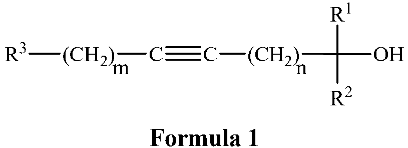 wherein (i) m = 0-3, (ii) n = 0-3, (iii) R³ is a hydrogen, a linear C₁-C₈ alkyl group, a branched C₃-C₈ alkyl group, a cyclic C₃-C₈ alkyl group, a five-member aromatic ring or a six-member aromatic ring and (iv) each of R¹ and R² is independently a linear C₁-C₈ alkyl group or a branched C₃-C₈ alkyl group.

4. The formulation of claim 3, wherein R³ is selected from the group of a hydrogen, a methyl group and a phenyl group.

5. The formulation of claim 3 or 4, wherein one or both of R¹ and R² is a methyl group.

6. The formulation of any of the preceding claims, wherein the tertiary alcohol comprises one or more of:
| **Alcohol Structure** | **Alcohol Structure** | **Alcohol Structure** | |
|---|---|---|---|
| 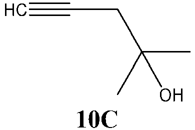 | 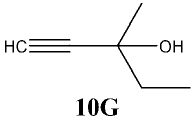 | 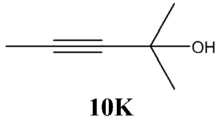 | |
| 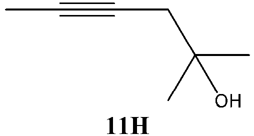 | 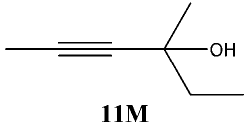 | 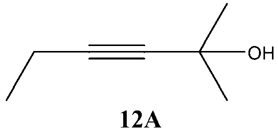 | |
| 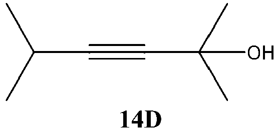 | 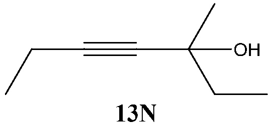 | 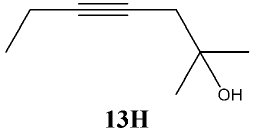 | |
| 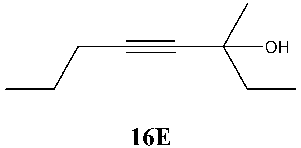 | 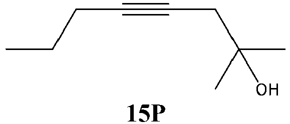 | 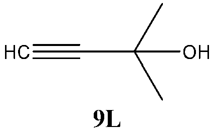 | |
| 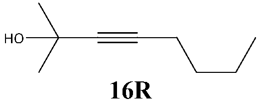 | 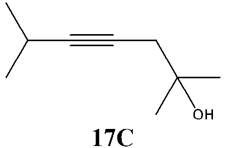 | 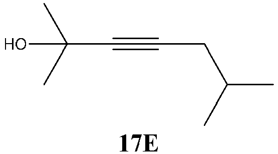 | |
| 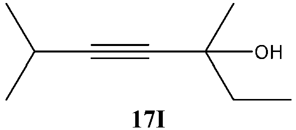 | 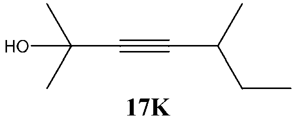 | 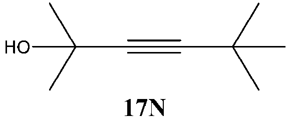 | |
| 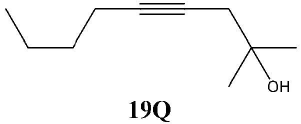 | 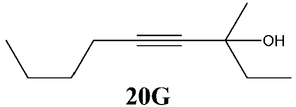 | 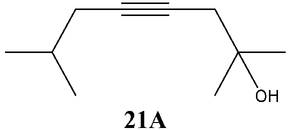 | |
| 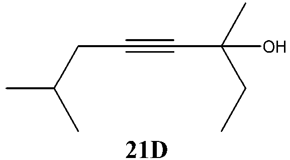 | 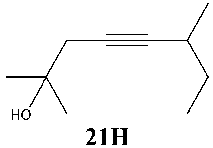 | 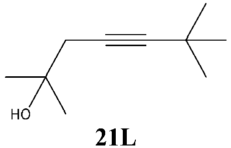 | |
| 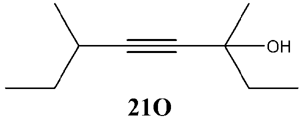 | 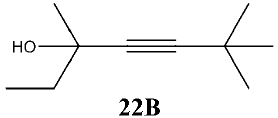 | 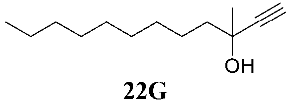 | |
| | | | |
|---|---|---|---|
| 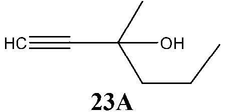 | 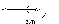 | | 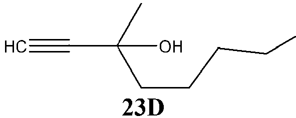 |
| 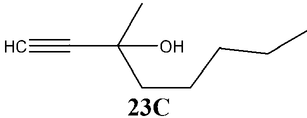 | 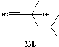 | | 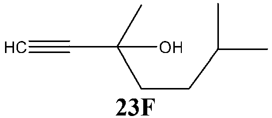 |
| 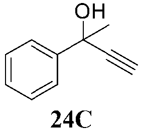 | | 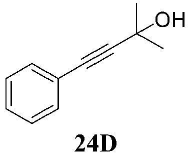 | |
wherein 2-methyl-3-octyn-2-ol (16R), 3,5-dimethyl-1-hexyn-3-ol (23E) and 3-methyl-1-octyn-3-ol (23C) are preferred.

7. The formulation of any of the preceding claims, wherein the formulation comprises 0.01 wt% ± 5% to 2 wt% ± 5% of the (ii) one or more tertiary alcohols.

8. The formulation of any of the preceding claims comprising:
**(i)** one or more alkynes comprising one or more of 5-decyne (3E), 1-decyne (3A) and 3-hexyne (1I); and
**(ii)** one or more tertiary alcohol selected from the group of 2-methyl-3-octyn-2-ol (16R), 3,5-dimethyl-1-hexyn-3-ol (23E) and 3-methyl-1-octyn-3-ol (23C).

9. The formulation of any of the preceding claims, wherein the (i) one or more alkynes comprises at least 95 wt% ± 5% of 5-decyne (3E) at least 95 wt% ± 5% of 3-hexyne (1I) or at least 95 wt% ± 5% of 1-decyne (3A).

10. The formulation of any of the preceding claims, wherein the formulation comprises 0.01 wt% ± 5% to 2 wt% ± 5% of the (ii) one or more tertiary alcohols selected from the group of 2-methyloct-3-yn-2-ol (16R), 3,5-dimethyl-1-hexyn-3-ol (23E) and 3-methyl-1-octyn-3-ol (23C).

11. The formulation of any of the preceding claims, wherein the (i) one or more alkynes comprises one or more high-purity alkyne having a concentration of water of less than about 50 ppm and/or having a concentration of carboxylic acids of less than 500 ppm ± 5%.

12. The formulation of any of the preceding claims, wherein the (i) one or more alkynes comprises one or more high-purity alkyne having a concentration of halogen-containing impurities of less than 50 ppm ± 5%, and preferably less than 10 ppm ± 5%.

13. A method for forming a film on at least one surface of a substrate comprising:
**a.** providing the at least one surface of the substrate in a reaction vessel;
**b.** forming at least one passivated surface by exposing the at least one surface to one or more of the formulations of any of the preceding claims.

14. The method of claim 13, wherein the method compromises a part of one or more of an atomic layer deposition process (ALD), a plasma enhanced ALD (PEALD) and a chemical vapor deposition process (CVD).

15. The method of claim13 or 14, further comprising depositing a nitride film or an oxide film on the at least one passivated surface.
